# NEUE EUROPÄISCHE PATENTSCHRIFT

(11) **EP 0 155 231 B2**
(45) Veröffentlichungstag und Bekanntmachung des Hinweises auf die Entscheidung über den Einspruch: **15.01.1997**
(45) Hinweis auf die Patenterteilung: 01.07.1992
(21) Anmeldenummer: 85810086.0
(22) Anmeldetag: 01.03.1985
(51) Int. Cl.: G03F 7/16, G03F 7/016, C08G 8/28

(54) **Verfahren zur Herstellung von Abbildungen**
Image-producing process
Procédé pour réaliser des images

(30) Priorität: 07.03.1984 GB 8405958; 01.12.1984 GB 8430376
(43) Veröffentlichungstag der Anmeldung: 18.09.1985
(73) Patentinhaber: CIBA-GEIGY AG, 4002 Basel (CH)
(72) Erfinder: Demmer, Christopher George, Dr., Cherry Hinton Cambridge CB1 3JQ (GB); Irving, Edward, Dr., Burwell Cambridge CB5 OAN (GB); Losert, Ewald, CH-4310 Rheinfelden (CH)

(56) Entgegenhaltungen:
- EP-A- 0 089 509
- EP-A- 0 092 444
- DE-A- 1 772 976
- DE-A- 2 301 075
- DE-A- 2 922 746
- GB-A- 1 330 932
- GB-B- 1 404 497
- JP-A-55 123 614
- JP-A-55 148 491
- JP-A-58 182 632
- JP-B- 499 642
- JP-B- 505 083
- JP-B- 562 696
- JP-B- 599 896
- JP-B- 6 313 528
- US-A- 3 738 835
- US-A- 3 849 137
- US-A- 4 308 368
- IBM TECHNICAL DISCLOSURE BULLETIN, Band 14, Nr. 2, Juli 1971, Seite 595, New York, US; L.M. ELIJAH et al.: "Photoresist application process"
- Journal of Polymer Science, Polymer Chemistry Edition, Vol. 15, 1977 C. C. Petropoulos: "Synthesis of Novel Photodegradable Poly(o-nitrobenzaldehyde Acetal) Polymers", pp. 1637-1644
- Chemistry & Chemical Industry, vol. 21, no. 5, Minoru Shibata: "Concerning Electrodeposition", 1968
- Journal of the Oil and Colour Chemists' Association, Vol. 59, No. 1, January 1976, H. Verdino: " Some examples of electrophoretic coatings for cathodic deposition"

## Beschreibung

Die vorliegende Erfindung betrifft ein Verfahren zur Herstellung von Abbildungen auf Substraten sowie die Verwendung dieser Methode bei der Herstellung von Druckplatten oder gedruckten Schaltungen, insbesondere zur Herstellung von gedruckten Schaltungen, die auf beiden Seiten eines Laminates aufgebracht wurden und die durch metallbeschichtete Oeffnungen im Laminat miteinander verbunden sind.

Beim herkömmlichen Bildherstellungsverfahren beschichtet man Substrate mit einem negativ arbeitenden Photolack, enthaltend ein photopolymerisierbares Material. Anschliessend belichtet man daß Substrat durch ein Negativ mit aktinischer Strahlung, so dass die belichteten Teile photopolymerisieren und daher weniger löslich werden, während die unbelichteten Stellen im wesentlichen unverändert bleiben.

In einem weiteren Arbeitsgang löst man den nicht photopolymerisierten Lack an den Stellen, die der Strahlung nicht ausgesetzt waren, mittels eines geeigneten Lösungsmittel weg. Das Lösungsmittel wird so gewählt, dass das photopolymerisierte Material unbeeinflusst bleibt. Diese Stufe ist auch als Entwicklung bekannt.

Nach der Entwicklung kann die freigelegte Oberfläche beispielsweise geätzt werden, um beispielsweise eine Druckplatte oder eine gedruckte Schaltung herzustellen.

Abschliessend kann die photopolymerisierte Lackschicht entfernt werden, beispielsweise durch chemische Verfahren, wie Behandlung mit einem geeigneten Lösungsmittel, oder durch mechanische Verfahren, wie beispielsweise durch Abbürsten, oder in der Regel durch eine Kombination beider Verfahrensweisen.

Aehnliche Verfahren, bei denen ein positiv arbeitender Photolack verwendet wird, sind bereits bekannt.

Darunter versteht man ein Material, das infolge von Belichtung durch aktinische Strahlung stärker löslich wird verglichen mit dem unbelichteten Material.

Belichtung durch eine Photomaske und Entwicklung führen bei diesem Verfahren zur Ausbildung eines positiven Bildes; d.h. eines Bildes, bei dem die unbelichteten Stellen nach dem Entwicklungsvorgang auf dem Substrat zurückbleiben.

In der Regel führen positiv arbeitende Photolacke zu höher aufgelösten Bildern als negativ arbeitende photopolymerisierbare Photolacke.

Nachteilig ist allerdings, dass positiv arbeitende Photolacke im allgemeinen nicht so gut auf Oberflächen haften wie Polymerisate, die durch Bestrahlung eines negativ arbeitenden Lackes erhalten wurden.

Verfahren, in denen positiv arbeitende Lacke angewendet werden, erfordern daher eine sorgfältigere Handhabung damit Beschädigungen vermieden werden.

Es besteht also das Bedürfnis, die Haftfestigkeit von positiv arbeitenden Photolacken zu vergrössern, um beispielsweise das Arbeiten mit solchen Lacken zu vereinfachen, und um so die Vorteile dieser Lacke voll ausnützen zu können.

Es wurde jetzt gefunden, dass die Adhäsion von positiv arbeitenden Photolacken merklich vergrössert werden kann, wenn der Lack galvanisch auf dem Substrat abgeschieden wird.

Die galvanische Abscheidung von lichtempfindlichen Schichten ist bekannt. In der GB-PS 1,489,402 werden beispielsweise photovernetzbare Harzzusammensetzungen beschrieben, die galvanisch auf metallischen Substraten, wie Aluminium, Eisen, Kupfer oder rostfreiem Strahl abgeschieden werden können.

Diese Zusammensetzungen basieren auf Vinyl- oder Vinylidenharzen, die freie Carbonsäuregruppen aufweisen, die ihrerseits an die Hauptkette gebunden sind.

In der US-PS 3,738,835 werden photovernetzbare Zusammensetzungen beschrieben, die elektrophoretisch als Ueberzüge auf Artikeln unregelmässiger Form abgeschieden werden können. Diese Zusammensetzungen sind Emulsionen und enthalten Polychloropren, einen Sensibilisator, einen Stabilisator, ein Bindemittel, ein Netzmittel, sowie N-Methyl-2-pyrrolidon und Triethanolamin.

In DE-A 23 01 075 wird die electrophoretische Abscheidung eines photohärtbaren Films beschrieben.

Diese Patente beschreiben jedoch nicht die galvanische Abscheidung von positiv arbeitenden Photolakken bzw. die Vorteile, die sich aus der galvanischen Abscheidung positiv-arbeitender Photolacke ergeben.

Die Erfindung betrifft ein Verfahren zur Herstellung metallischer Abbildungen auf der Metalloberfläche eines metallkaschierten Laminates, wobei besagtes Verfahren folgende Arbeitsschritte enthält:
a) galvanische Abscheidung einer Schicht eines positiv arbeitenden Photolackes, der sowohl salzbildende Gruppen als auch photoempfindliche Gruppen im gleichen Polymer Molekül enthält auf das metallkaschierte Laminat wobei eine einheitliche Bedeckung aus besagtem positiv arbeitenden Photolack entsteht,
b) Belichtung der aufgebrachten Schicht durch ein vorbestimmtes Muster aktinischer Strahlung, wodurch die der Strahlung ausgesetzten Stellen der aufgebrachten Schicht gegenüber einem Entwicklungsmittel löslicher werden als die unbestrahlten Stellen,
c) Entfernen der aufgebrachten Schicht von den belichteten Stellen durch Kontakt mit einem Entwickler,
d) Entfernen der freigelegten Metalloberfläche mittels eines geeigneten Aetzmittels und
e) Entfernen des restlichen positiv arbeitenden Photolackes durch Kontakt mit einem geeigneten Lösungsmittel.

Substrate, auf denen der positiv arbeitende Photolack galvanisch abgeschieden werden kann, müssen elektrisch leitfähig sein. Dabei handelt es sich um Metalle, wie Stahl, Aluminium oder Kupfer, die als metallbeschichtetes Laminat vorliegen.

Abbildungen die nach dem erfindungsgemässen Verfahren hergestellt werden, lassen sich als Druckplatten oder bei der Herstellung von gedruckten Schaltungen verwenden.

Insbesondere bei der Herstellung von gedruckten Schaltungen aber auch bei der Herstellung von Druckplatten handelt es sich bei dem Substrat, das mit dem Photolack beschichtet wird, um ein Metall. Dieses Metall wird nach der Bildherstellung an den freigelegten Stellen weggeätzt. Anschliessend wird der verbliebene Photolack durch weiteren Kontakt mit einem Lösungsmittel entfernt; bei diesem Lösungsmittel kann es sich um das gleiche handeln, wie in der ersten Entwicklungsstufe zur Erzeugung des Bildes, es kann sich aber auch um ein unterschiedliches Lösungsmittel handeln.

Die Entfernung des Photolackes nach der Bildherstellung und dem Aetzprozess kann vorzugsweise durch nochmaliges Belichten des gesamten Substrates ohne die Photomaske erleichtert werden. Dieser zusätzliche Verarbeitungsschritt des bildtragenden Substrates ist besonders bei der Herstellung von gedruckten Schaltungen von Interesse, bei denen ein flaches Substrat beidseitig mit einer Schaltung versehen ist, und worin beide Schaltungen über leitfähige Brücken miteinander verbunden sind. Bei der Herstellung dieses Typs von gedruckten Schaltungen geht man von beidseitig metallbeschichteten Laminaten aus, die Oeffnungen enthalten, die ihrerseits mit Metall belegt sind.

Beim Herstellungsprozess dieses Typs von gedruckten Schaltungen ist es wesentlich, dass das Metall in den Oeffnungen während des Aetzprozesses vor einem Angriff des Aetzmittels durch den Photolack geschützt wird; eine Zerstörung der leitfähigen Verbindungen zwischen beiden Seiten der Schaltung würde den elektrischen Kontakt zwischen beiden Schaltungsteilen verhindern oder beeinträchtigen.

Es ist nur selten möglich, die gesamte Auskleidung der Oeffnung im Laminat vollständig zu bestrahlen; verwendet man daher einen flüssigen Photolack auf einem solchen Laminat, so führt der normale Entwicklungs- und Aetzprozess mit hoher Wahrscheinlichkeit zur Zerstörung der Metallbrücken, obgleich dies nicht beabsichtigt war. Zur Vermeidung solcher Schwierigkeiten beschichtet man solche Laminate in der Regel mit festen Photolacken, die die Oeffnung überbrücken; es ist deshalb nicht länger nötig, die gesamte Oberfläche der Oeffnung zu bestrahlen. Belichtung, Entwicklung und Entfernen des restlichen Films nach dem Aetzprozess werden dann in üblicher Weise durchgeführt.

Dieses Verfahren besitzt aber einen entscheidenden Nachteil. Um eine Abbildung möglichst hoher Auflösung zu erhalten, ist es nötig, den festen Photolack so dünn wie möglich aufzutragen.

Bei der Herstellung solch dünner Filme ist es aber unvermeidlich, dass von Zeit zu Zeit Inhomogenitäten, wie beispielsweise kleine Löcher (sogenannte Pinholes), auftreten.

Wenn sich solch ein Pinhole an der Stelle eines leitfähigen Uebergangs zwischen beiden Schaltungsseiten befindet, so ist der Schutz dieses Ueberganges vor einem Angriff des Aetzmittels nicht länger gegeben. Die elektrische Verbindung zwischen beiden Seiten wird zerstört und die Funktion der Schaltung ist nicht länger gewährleistet.

Arbeitet man mit einem positiven Photolack, so braucht kein fester Film zum Beschichten des Substrates verwendet zu werden, da die unbestrahlten Flächen der Oeffnungen nach dem Entwicklungsvorgang bedeckt bleiben.

Es bleibt jedoch das Problem bestehen, die Oberfläche einer Oeffnung im Laminat einheitlich zu bedecken.

Verfahren, wie Aufrollen, Aufbürsten oder Vorhangguss, sind im allgemeinen für die Beschichtung glatter Oberflächen entwickelt worden und ergeben häufig keine regelmässigen Filme, wenn Oeffnungen im unterliegenden Substrat vorhanden sind.

Auch Tauchverfahren führen in der Regel zu Problemen, da kleine Oeffnungen durch den Film blockiert werden. Man erhält zwar einen guten Schutz vor dem Angriff des Aetzmittels, es ist jedoch schwierig, das Harz anschliessend zu entfernen, um elektrische Anschlüsse herzustellen.

Es wurde nun gefunden, dass dieser Nachteil der vorbekannten Verfahren bei der Herstellung dieses Typs von gedruckten Schaltungen vermieden werden kann, wenn der positive Photolack galvanisch als Film abgeschieden wird.

Die galvanische Abscheidung positiver Photolacke führt zur einheitlichen Bedeckung des Substrates; dies ist besonders bei Substraten wichtig, die mit relativ dünnen Photolackschichten bedeckt werden sollen und die Kanten oder beschichtete durchgehende Oeffnungen aufweisen.

Durch Verwendung einheitlicher dünner Lackfilme lässt sich eine verbesserte Auflösung von Strukturen erreichen als mit herkömmlichen Filmen oder mit flüssigen Photolacken. Ein weiterer Vorteil besteht darin, dass die Grösse der filmbedeckten Fläche um eine metallbedeckte durchgehende Oeffnung in der Leiterplatte verringert werden kann. da kein fester Film verwendet wird, der eine gewisse Auflagefläche benötigt. Dadurch ist es möglich, einen höheren Flächenanteil der Leiterplatte für Leiterlinien zu nutzen.

Ebenso von Vorteil ist es, dass Formulierungen galvanisch abscheidbarer Photolacke nur einen geringen Lösungsmittelanteil benötigen und aus Lösungen mit hohem Feststoffanteil abgeschieden werden können, was aus gewerbehygienischen und ökologischen Gründen erwünscht ist.

Schliesslich ist es auch möglich, den Beschichtungsprozess vollständig zu automatisieren, insbesondere dann, wenn hohe Stückzahlen herzustellen sind.

Nach der galvanischen Abscheidung erfolgt die bildmässige Belichtung des Films mit aktinischer Strahlung, das Entfernen der belichteten Stellen des Photolackes durch Kontakt mit einem Entwicklungsmittel, das Entfernen des Metalls durch Aetzen der freigelegten Oberfläche mit einem Aetzmittel, gegebenenfalls eine erneute Belichtung der gesamten verbliebenen Beschichtung, und schliesslich das Entfernen des restlichen Photolackes durch Kontakt mit einem geeigneten Lösungsmittel.

Das Entfernen des restlichen galvanisch abgeschiedenen Photolackes kann in einer einzigen Stufe erfolgen; es kann ein Lösungsmittel verwendet werden, das effektiver wirkt als der Entwickler, der in der dritten Verfahrensstufe eingesetzt wurde. Es kann aber auch der Entwickler aus der dritten Stufe verwendet werden, nur wird er jetzt länger einwirken gelassen.

Vorzugsweise entfernt man den restlichen galvanisch abgeschiedenen Photolack jedoch, indem man den gesamten Film nochmals aktinischer Strahlung aussetzt; dadurch wird der Film in einen löslicheren Zustand übergeführt und kann daher schneller entfernt werden oder es können mildere Entwicklungsbedingungen angewendet werden, verglichen mit einem unbestrahlten Film.

Die Erfindung betrifft daher vorzugsweise auch ein Verfahren zur Herstellung metallischer Abbildungen, wie oben beschrieben, worin vor der letzten Verfahrensstufe e) ein weiterer Schritt d 1) ausgeführt wird, wobei das entwickelte und geätzte Laminat aktinischer Strahlung ausgesetzt wird, so dass der restliche galvanisch abgeschiedene Photolack in einen löslicheren Zustand übergeführt wird.

Zum Gegenstand der Erfindung gehören auch die durch das erfindungsgemässe Verfahren erzeugten Abbildungen.

Der Ausdruck "Belichtung mit einem vorbestimmten Muster aktinischer Strahlung" bedeutet sowohl eine Belichtung durch eine Photomaske, die ein vorbestimmtes Muster enthält, beispielsweise ein Diapositiv, sowie die Belichtung durch einen Laserstrahl der beispielsweise computergesteuert über die Oberfläche bewegt wird, und auf diese Weise ein Bild erzeugt.

Die positiv arbeitenden Photolacke, die zur Durchführung des erfindungsgemässen Verfahrens geeignet sind, müssen galvanisch abscheidbar sein; sie werden deshalb in Form von Salzen eingesetzt. Folglich müssen sie Gruppen im Molekül aufweisen, die zur Salzbildung fähig sind. Beispiele für solche Gruppen sind Aminogruppen, Carbonsäure-, Sulfonsäure- oder Phosphonsäuregruppen.

Die Photolacke müssen darüber hinaus auch eine vergrösserte Löslichkeit entwickeln, nachdem sie aktinischer Strahlung ausgesetzt waren.

Materialien oder Mischungen solcher Materialien mit diesen Eigenschaften sind bekannt. Dabei handelt es sich beispielsweise um Polyoxymethylen-Polymere, wie in der US-PS 3,991,033 beschrieben, oder um o-Nitrocarbinolester, wie in der US-PS 3,849,137 beschrieben. Es kann sich aber auch um o-Nitrophenylacetale handeln, deren Polyester oder endgruppenverkappte Derivate, wie sie beispielsweise in der US-PS 4,086,210 beschrieben sind.

Ferner kommen Benzo- oder Naphthochinondiazid-sulfonsäureester, wie beispielsweise in den GB-PSS 1,227,602, 1,329,888 und 1,330,932 oder in der US-PS 4,306,010 beschrieben, in Frage.

Im erfindungsgemässen Verfahren verwendet man daher vorzugsweise als lichtempfindliche Materialien Salze von Polyoxymethylen-Polymeren mit salzbildenden Gruppen, von o-Nitrocarbinolestern mit salzbildenden Gruppen, von o-Nitrophenylacetalen, deren Polyestern oder endgruppenverkappten Derivaten mit salzbildenden Gruppen und von Benzo- und Naphthochinondiazid-sulfonsäureestern mit salzbildenden Gruppen.

Bevorzugt als salzbildende Gruppen werden Aminogruppen, Carboxylgruppen, Sulfonsäure- und Phosphonsäuregruppen.

Salze von Verbindungen mit Aminogruppen stellt man beispielsweise durch Umsetzung dieser Verbindungen mit einer organischen oder anorganischen Säure her, beispielsweise durch Umsetzung mit Essigsäure, Milchsäure, Trichloressigsäure, Methansulfonsäure, Glykolsäure, p-Toluolsulfonsäure, Salzsäure oder Schwefelsäure.

Salze von Verbindungen mit Säuregruppen stellt man beispielsweise durch Umsetzung dieser Verbindungen mit organischen oder anorganischen Basen her, beispielsweise durch Umsetzung mit Triethylamin, Triethanolamin, Diethanolamin, Pyridin, Morpholin, Natrium- oder Kaliumhydroxid, Natrium- oder Kaliumcarbonat oder Natrium- oder Kaliumethoxid.

Die Einführung salzbildender Gruppen in diese Moleküle ist eine wohlbekannte Technik. So lässt sich beispielsweise ein lichtempfindliches o-Nitrophenylacetal aus o-Nitrobenzaldehyd und einem zweiwertigen Alkohol herstellen; dabei kann jeweils eine oder beide der Komponenten freie oder geschützte Amino- bzw. Säuregruppen enthalten.

Nach erfolgter Kondensation werden die Schutzgruppen. falls vorhanden, abgespalten. Polyester dieser Acetale oder ähnlicher Acetale, denen aber salzbildende Gruppen fehlen, können hergestellt werden, indem man eine Dicarbonsäure oder ein reaktives Derivat besagter Dicarbonsäure, beispielsweise deren Anhydrid, mit dem Acetal umsetzt. Dabei enthält die Dicarbonsäure oder ihr reaktives Derivat geeignete salzbildende Gruppen.

So lässt sich beispielsweise das Anhydrid einer Dicarbonsäure, das noch eine weitere Carboxylgruppe enthält, beispielsweise Trimellitsäureanhydrid, verwenden.

Man kann aber auch ein Acetal, das salzbildende Gruppen enthält oder auch nicht, durch Umsetzung mit einer. Carbonsäure oder einem ihrer reaktiven Derivate reagieren lassen, wobei die Carbonsäure oder ihr reaktives Derivat mindestens eine salzbildende Gruppe trägt; dabei entsteht ein endgruppenverkapptes Acetal.

Polymere enthaltend o-Nitrocarbinolesterreste und freie Carbonsäuregruppen kann man durch Copolymerisation eines o-Nitrocarbinolesters einer ungesättigten Carbonsäure, insbesondere Acrylsäure oder Methacrylsäure, mit der freien Säure oder einer anderen ungesättigten Säure erhalten; gegebenenfalls sind noch weitere ungesättigte Monomere anwesend. Die Copolymerisation erfolgt nach an sich bekannten Techniken.

Polymere, die o-Nitrocarbinolesterreste und freie Carbonsäuregruppen oder Aminogruppen enthalten, können auch durch Veresterung von Carboxylgruppen von Polycarbonsäuren mit einem aromatischen Carbinol erhalten werden. Sowohl Polycarbonsäure als auch aromatisches Carbinol können freie oder geschützte Carboxyl- oder Aminogruppen enthalten. Falls gewünscht, können die Schutzgruppen nach der Veresterung abgespalten werden.

Lichtempfindliche Salze enthaltend die Chinondiazidgruppe können hergestellt werden, indem man ein geeignetes reaktives Trägerharz mit einer Chinondiazidsulfonsäure oder einem ihrer reaktiven Derivate, wie beispielsweise dem Halogenid, dem Anhydrid oder dem Ester, umsetzt.

Die Verbindungen lassen sich aber auch durch Umsetzung eines geeigneten reaktiven Monomeren mit solch einer Sulfonsäure bzw. einem ihrer reaktiven Derivate herstellen; anschliessend werden die Umsetzungsprodukte in einem nachfolgenden Additions- oder Kondensationsschritt mit einem geeigneten Reaktionspartner zu dem polymeren Endprodukt reagieren gelassen.

Falls die monomeren Verbindungen oder das Ausgangsharz salzbildende Gruppen enthalten, kann die Salzbildung, wie oben beschrieben, unmittelbar nach der Herstellung der Endprodukte erfolgen.

Liegen solche salzbildenden Gruppen nicht vor, so können sie nach an sich bekannten Methoden in das Harz eingeführt werden.

So lassen sich beispielsweise Harze mit aktiven Wasserstoffatomen in einer Mannich Reaktion mit Aldehyd und Amin umsetzen. Die resultierende Mannichbase bildet mit Säuren Salze.

Führt man hingegen die Mannich Reaktion mit Aminosäuren durch, so besitzt das Reaktionsprodukt freie Säuregruppen und bildet Salze mit Basen.

Zur Gruppe der Chinondiazidsalze zählen vorzugsweise solche Verbindungen mit einem Novolak-Grundgerüst; dabei werden die Chinondiazidgruppen und die löslichkeitsvermittelnden Gruppen entweder in den Novolak eingeführt, oder diese Gruppen befinden sich bereits im Phenol, das zur Herstellung des Novolaks eingesetzt wird.

Salze dieser lichtempfindlichen Stoffe werden nach an sich bekannten Verfahren hergestellt, insbesondere durch Neutralisation der Säure oder der Base in wässrigem Medium, wodurch eine Salzlösung entsteht.

Solche Salze werden in der Regel nicht isoliert, sondern werden in Lösung direkt zur galvanischen Abscheidung im erfindungsgemässen Verfahren eingesetzt.

Bevorzugt verwendbare positive Photolacke im Rahmen dieser Erfindung sind Verbindungen der Formel I oder der Formel II 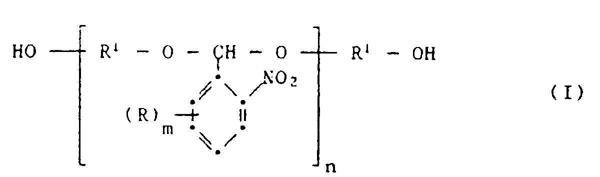 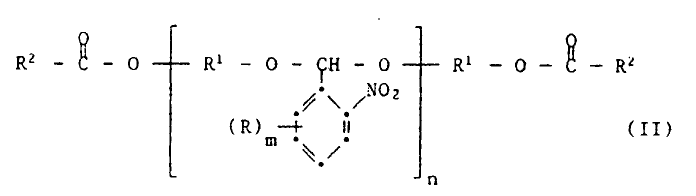 oder es handelt sich um Verbindungen enthaltend das Strukturelement der Formel III 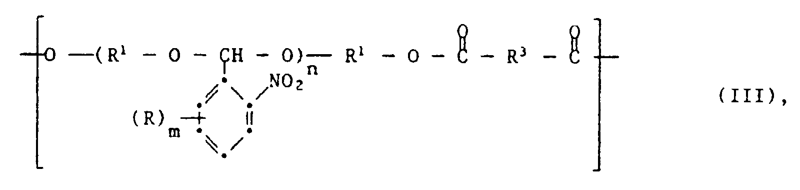 worin
m O oder eine ganze Zahl von 1 bis 4 ist,
n eine ganze Zahl von 1 bis 20 ist,
R Alkyl, Alkoxy, Nitro, Amino oder Carboxyl bedeutet, wobei im Falle m>1 mehrfach auftretende Gruppen R innerhalb der gegebenen Definition unterschiedlich sein können,
worin
R¹ ein divalenter organischer Rest ist, der gegebenenfalls mit Amino-oder Carboylgruppen substituiert sein kann, vorzugsweise jedoch C₅-C₁₅Alkylen, lineares durch ein oder mehrere Heteroatome oder -gruppen, wie beispielsweise Sauerstoff, Stickstoff, Schwefel, -CO- oder -SO₂-, unterbrochenes C₄-C₁₅Alkylen, oder lineares durch eine C₅-C₇Cycloalkylengruppe unterbrochenes C₂-C₆Alkylen bedeutet, worin
R² ein monovalenter organischer Rest ist, der gegebenenfalls mit Amino- oder Carboxylgruppen substituiert ist, wie beispielsweise C₁-C₁₅Alkyl, C₆-C₁₀Aryl, C₇-C₂₀Aralkyl oder C₇-C₂₀Alkaryl, und worin R³ ein divalenter organischer Rest ist, der gegebenenfalls mit Amino- oder Carboxylgruppen substituiert ist, wie beispielsweise C₂-C₁₅Alkylen oder C₆-C₁₀Arylen;
mit der Massgabe, dass wenigstens eine der Gruppen R, R¹, R² oder R³ eine Amino- oder Carboxylgruppe enthält.

Weitere bevorzugte galvanisch abscheidbare positiv-arbeitende Photolacke, die als Salze im Rahmen dieser Erfindung verwendet werden können, sind Copolymere eines o-Nitrocarbinolesters einer ungesättigten Säure mit der freien Säure oder einer anderen ungesättigten Säure, gegebenenfalls noch mit einem oder mehreren zusätzlichen ungesättigten Monomeren.

Diese Copolymeren haben ein Molekulargewicht von mindestens 500 und enthalten mindestens 5 Gew.% vom Gesamtmolekül (bezogen auf das Molekulargewicht) an aromatisch-carbozyklischen oder aromatischheterozyklischen o-Nitrocarbinolestergruppen der Formel IV 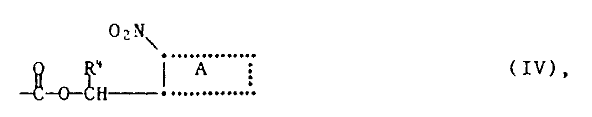 worin A einen aromatisch-carbozyklischen oder aromatisch-heterozyklischen Ring bedeutet, der gegebenenfalls substituiert sein kann und 5 bis 14 Glieder umfasst, worin R⁴ Wasserstoff, C₁-C₈Alkyl oder eine gegebenenfalls substituierte Aryl- oder Aralkylgruppe bedeutet, wobei die gegebenenfalls an A oder R⁴ vorhandenen Substituenten C₁-C₈Alkyl- oder -Alkoxyreste sind, oder Halogen, Nitro, Amino oder Carboxyl bedeuten. Geeignete Ringsysteme A können ein- oder mehrkernig sein. Dabei handelt es sich beispielsweise um Benzol-, Naphthalin-, Anthracen-, Anthrachinon-, Phenanthren- oder Pyridinringe.

Beispiele für geeignete aromatische o-Nitrocarbinole, die zur Herstellung von o-Nitrocarbinolestern verwendet werden können, sind
o-Nitrobenzylalkohol, 2-Nitroveratrylalkohol, 6-Nitroveratrylalkohol, 2-Nitro-4-aminobenzylalkohol, 2-Nitro-4-dimetylaminobenzylalkohol, 2-Nitro-5-dimethylaminobenzylalkhol, 2-Nitro-5-aminobenzylalkohol, 2-Nitro-4,6-dimethoxybenzylalkohol, 2,4-Dinitrobenzylalkohol, 3-Methyl-2,4-dinitrobenzylalkohol, 2-Nitro-4-methylbenzylalkohol, 2,4,6-Trinitrobenzylalkohol, 2-Nitrobenzhydrol, 2,2'-Dinitrobenzhydrol, 2,4-Dinitrobenzhydrol, 2,2',4,4'-Tetranitrobenzhydrol, 2-Nitro-4-methylaminobenzylalkohol, 2-Nitro-3-hydroxymethylnaphthalin, 1-Nitro-2-hydroxymethylnaphthalin, 1-Nitro-2-hydroxymethylanthrachinon, 3-Methoxy-4-(2-nitratoethoxy)-6-nitrobenzylalkohol und 2-Nitro-3-hydroxymethylpyridin.

Weitere bevorzugte galvanisch abscheidbare positive Photolacke, deren Salze im Rahmen dieser Erfindung verwendet werden, sind Chinondiazidsulfonylester von phenolischen Novolaken mit salzbildenden Gruppen.

Solche Ester enthalten wenigstens zwei, vorzugsweise zwischen zwei und zwanzig, wiederkehrende Struktureinheiten der Formel V 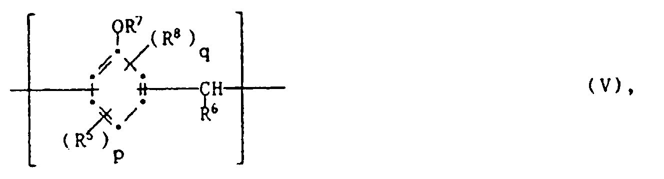
worin R⁵ Halogen, Hydroxyl oder Alkoxy ist, oder eine gegebenenfalls veresterte Carbonsäure- oder Sulfonsäuregruppe darstellt, oder gegebenenfalls durch eine Carboxylgruppe substituiertes Alkyl, Alkenyl oder Aryl bedeutet, oder worin R⁵ ein Rest der Formel -NR⁹R¹⁰, -COR¹¹, -OCOR¹², -OSO₂R¹² oder -OSO₂R¹³ ist, oder worin einer der Reste R⁵ eine Gruppe der Formel VI ist 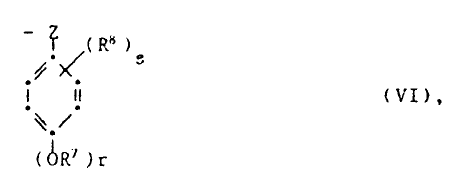 wobei besagte Gruppe der Formel VI mit benachbarten aromatischen Ringen durch Reste der Formel -CHR⁶- verbunden sein kann,
worin p O, 1, 2 oder 3 ist, r 0 oder 1 bedeutet und s O oder 1 darstellt,
worin R⁶ Wasserstoff oder Alkyl, Aryl oder Carboxyl bedeutet, worin R⁷ Wassserstoff ist oder gegebenenfalls durch Hydroxy oder Alkoxy substituiertes Alkyl bedeutet, oder
worin R⁷ eine Gruppe der Formel -SO₂R¹³, -SO₂R¹² oder -COR¹² ist, worin wenigstens 4 % vorzugsweise jedoch 8 %, der Reste R⁷ des Esters mit den wiederkehrenden Struktureinheiten der Formel V eine Gruppe der Formel -SO₂R¹³ darstellen,
worin R⁸ eine salzbildende Gruppe, insbesondere eine Carboxylgruppe -COOH, eine Sulfonsäuregruppe SO₃H, eine Phosphonsäuregruppe -(P)(OH)₂, einen Rest der Formel -CH₂-SO₃H oder einen Rest der Formel -CHR⁶-Y-R¹⁴-X darstellt, worin
q 0 oder 1 ist,
R⁹ Wasserstoff oder Alkyl bedeutet oder -COR¹², -SO₂R¹² oder -SO₂R¹³ ist, worin
R¹⁰ Wasserstoff oder Alkyl ist, R¹¹ ein monovalenter aliphatischer oder cycloaliphatischer Rest ist, R¹² einen monovalenten aliphatischen, cycloaliphatischen, aromatischen oder araliphatischen Rest bedeutet, worin R¹³ eine 1,2-Benzo- oder Naphthochinondiazidgruppe der Formel VII oder VIII ist 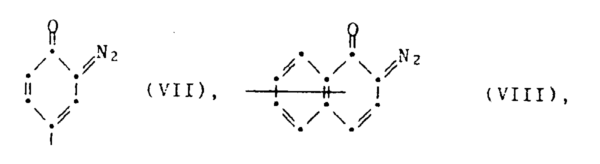 wobei die freie Valenz im Naphthochinon der Formel VIII sich in 4-oder 5-Position befindet, worin
R¹⁴ eine divalente aliphatische, aromatische oder araliphatische Gruppe ist, die gegebenenfalls durch eine Carboxylgruppe, eine Sulfonsäuregruppe oder eine Phosphonsäuregruppe substituiert sein kann, worin Y Schwefel oder einen Rest -NR¹⁵- bedeutet, wobei R¹⁵ Wasserstoff ist oder Alkyl bedeutet, das gegebenenfalls durch eine Carboxylgruppe oder eine gegebenenfalls veretherte Hydroxylgruppe substituiert ist, oder
worin R¹⁴ und R¹⁵ zusammen eine C₄-C₅Alkylenkette darstellen, die durch ein Stickstoff- oder Schwefelatom unterbrochen sein kann, worin
X eine Carboxylgruppe oder eine Sulfonsäuregruppe ist, oder, falls Y -NR¹⁵- ist, auch Wasserstoff, eine Phosphonsäuregruppe, eine Hydroxylgruppe, oder eine Gruppe -NR¹⁶R¹⁷ sein kann, worin R¹⁶ und R¹⁷ unabhängig voneinander Wasserstoff, Alkyl, Aryl, Aralkyl oder Alkenyl sind, wobei jeder dieser Reste durch Hydroxyl substituiert sein kann, und worin
Z Sauerstoff, Schwefel, Carbonyl oder Sulfonyl bedeutet oder C₁-C₆Alkylen ist , das gegebenenfalls durch ein Halogenatom, eine Carboxylgruppe, einen C₁-C₁₂Alkylrest oder einen C₆-C₁₂Arylrest substituiert ist, wobei besagte Alkyl- oder Arylreste ihrerseits gegebenenfalls durch Halogen oder Hydroxyl substituiert sein können; mit der Massgabe, dass besagter Ester wenigstens eine Carbonsäure-, Sulfonsäure- oder Phosphonsäuregruppe oder eine Aminogruppe innerhalb der unter R⁵ , R⁶ und R⁸ definierten Reste enthält.

Vorzugsweise enthalten die im Zusammenhang mit der Formel V definierten Alkyl- oder Alkenylreste, sowie der Alkylteil der Aralkylgruppen, nicht mehr als 20 Kohlenstoffatome, insbesondere bis zu 10 Kohlenstoffatome.

Die Arylgruppen und der Arylteil der Aralkylreste enthalten in der Regel ebenfalls bis zu 20 Kohlenstoffatome, vorzugsweise bis zu 15 Kohlenstoffatome.

Insbesondere bedeutet p 0 oder 1, und R⁵ bedeutet Chlor oder Brom, Hydroxy, C₁-C₄Alkoxy, C₁-C₈Alkyl, Carboxyl, eine Sulfonsäuregruppe, einen Rest der Formel -OSO₂R¹², -OSO₂R¹³, -OCOR¹² oder einen Rest der Formel VI,
R⁶ ist Wasserstoff, R⁷ ist Wasserstoff, C₁-C₄Alkyl, das gegebenenfalls durch Hydroxy oder C₁-C₄Alkoxy substituiert ist, oder R⁷ ist ein Rest der Formel -COR¹², -SO₂R¹² oder -SO₂R¹³, wobei R⁷ und r so ausgewählt werden, dass wenigstens 5 %, vorzugsweise 9 % oder mehr, der Gruppen R⁷ SO₂R¹³ darstellen, R⁸ ist eine Carboxyl- oder Sulfonsäuregruppe oder eine Gruppe der Formel -CH₂-NR¹⁵-R¹⁴-X',
R¹², R¹³, R¹⁴ und R¹⁵ besitzen die oben definierten Bedeutungen, X' ist Wasserstoff, eine Carboxyl- oder Sulfonsäuregruppe, eine Hydroxylgruppe oder ein Rest -NR¹⁶R¹⁷, worin R¹⁶ und R¹⁷ die oben definierten Bedeutungen besitzen,
q und s werden so gewählt, dass wenigstens 4 %, ganz besonders bevorzugt jedoch von 8 % bis 50 %, der Gruppen der Formel V einen Rest R⁸ enthalten.

Besonders bevorzugte Photolacke im Rahmen dieser Erfindung sind Salze von Verbindungen der Formel I oder Verbindungen enthaltend Strukturelemente der Formel III, worin m 0 ist, n eine ganze Zahl von 1 bis 15 ist, R¹ C₅-C₁₀Alkylen bedeutet oder eine lineare C₂-C₄Alkylenkette ist, die von einer Cyclohexylengruppe unterbrochen ist, worin R³ 1,2-, 1,3- oder 1,4-Phenylen ist, das durch eine Carboxylgruppe substituiert ist.

Weitere besonders bevorzugte Photolacke sind diejenigen Salze von Verbindungen der Formel IV, worin A ein Benzolring ist, der gegebenenfalls substituiert sein kann, und worin R⁴ Wasserstoff bedeutet.

Weitere bevorzugte positive Photolacke im Rahmen dieser Erfindung sind Salze von Verbindungen enthaltend 2 bis 15 der wiederkehrenden Struktureinheiten der Formel V, wie oben definiert, worin p 0 oder 1 ist, R⁵ C₁-C₄Alkyl, Hydroxyl, einen Rest der Formel -OSO₂R¹³, oder eine Gruppe der Formel VI, wie oben definiert, bedeutet, worin Z eine durch eine Carboxylgruppe substituierte Alkylengruppe ist, worin s 0 ist und r 1 bedeutet, worin R⁶ Wasserstoff ist, R⁷ Wasserstoff oder Methyl, Ethyl, Isopropyl, n-Butyl, 2-Hydroxyethyl, 2-Hydroxypropyl, 2-Methoxyethyl oder 2-Butoxyethyl bedeutet oder Acetyl, Benzoyl, Methansulfonyl, Benzolsulfonyl oder p-Toluolsulfonyl ist, oder einen Rest -SO₂R¹³ bedeutet, mit der Massgabe, dass 9 % bis 50 % der Reste R⁷ -SO₂R¹³ sind, worin R⁸ eine Carboxyl- oder Sulfonsäuregruppe ist oder ein Rest der Formel -CH₂-NR¹⁸R¹⁹ ist, worin R¹³ eine Naphthochinogruppe der Formel VIII ist, worin R¹⁸ Wasserstoff oder C₁-C₄Alkyl ist, das gegebenenfalls durch eine Hydroxygruppe, eine Aminogruppe oder eine Carboxylgruppe substituiert ist, worin R¹⁹ C₁-C₄Alkyl oder -Hydroxyalkyl ist, und worin q, für den Fall, dass R⁵ eine Gruppe der Formel VI darstellt, 0 bedeutet und worin q, für den Fall, dass R⁵ keine Gruppe der Formel VI darstellt, so ausgewählt wird, dass wenigstens 10 %, vorzugsweise von 20 % bis 100 %, der Reste der Formel V eine Gruppe der Formel R⁸ besitzen.

Die lichtempfindlichen Zusammensetzungen können gegebenenfalls Sensibilisatoren enthalten; dazu zählen beispielsweise Michlers Keton, Benzophenone oder Thioxanthone.

Weiterhin können andere wasserlösliche oder wasserdispergierbare Substanzen den positiv-arbeitenden Photolacken zugemischt werden, bevor diese galvanisch abgeschieden werden. Solche Zusätze können die Qualität der abgeschiedenen Filme verbessern. Bei diesen Substanzen handelt es sich beispielsweise um Acrylharze oder um Alkydharze, sowie um Polybutadiene mit salzbildenden Substituenten oder um Harze, die in der US-PS 4,362,853 beschrieben werden.

Die galvanische Abscheidung in der ersten Stufe des erfindungsgemässen Verfahrens erfolgt nach an sich bekannten Verfahrensweisen.

Ueblicherweise verwendet man Spannungen bis zu 200 V und Einwirkungszeiten bis zu 5 Minuten. Die konkreten Bedingungen für einen speziellen Photolack, ein spezielles Substrat und eine definierte Filmdicke lassen sich vom Fachmann anhand von Routinetests ermitteln.

Die Wahl des jeweiligen Entwicklers richtet sich nach der Art des verwendeten Photolackes und der entstehenden Photolyseprodukte und kann wässrige oder organisch-wässrige Lösungen von Säuren oder Basen sowie organische Lösungsmittel oder Mischungen dieser Lösungsmittel umfassen.

Bevorzugt wird die Verwendung einer Base oder einer Säure als Entwickler, die Salze mit besagten Gruppen der Photolacke bilden, und daher die bestrahlten Teile des Photolackes lösen.

Bei diesen bevorzugten Entwicklern handelt es sich beispielsweise um ein- bis fünfprozentige wässrige Lösungen von Natrium- oder Kaliumhydroxid oder -carbonat. Diese Entwicklerlösungen lassen sich bei Photolacken anwenden, die saure Gruppen enthalten.

Es handelt sich aber auch bevorzugt um ein- bis fünfprozentige wässrige Lösungen von Essigsäure, Milchsäure, Glykolsäure oder p-Toluolsulfonsäure. Diese Entwicklerlösungen lassen sich verwenden, wenn Photolacke mit Aminogruppen eingesetzt werden.

Die Verwendung von organischen Lösungsmitteln als Entwicklerflüssigkeiten ist vor allem dann angebracht, wenn Photolacke eingesetzt werden, die nur geringe Anteile an salzbildenden Gruppen aufweisen. Bei Bestrahlung zerfallen diese Lacke in kleinere Bruchstücke, die keine oder nur wenig salzbildende Gruppen besitzen.

Typische organische Lösungsmittel, die als Entwicklerflüssigkeiten Anwendung finden, sind beispielsweise Cyclohexanon, 2-Ethoxyethanol, Toluol, Aceton, sowie Mischungen zweier oder mehrerer dieser Lösungsmittel.

Die endgültige Entfernung des restlichen Photolackes wird nach der ersten Entwicklung und anschliessendem Aetzen des Bildes vorgenommen. Vor dieser Entfernung kann der Lack aktinischer Strahlung ausgesetzt werden, obgleich dies nicht zwingend ist. In dieser Stufe kann das gleiche Lösungsmittel oder die gleiche lösung verwendet werden wie bei der Entwicklung der bildmässig belichteten Stellen. Es können jetzt aber auch stärker lösende Mittel eingesetzt werden oder die Einwirkungsdauer des Lösungsmittels oder der Entwicklungslösung kann länger sein als bei der ersten Entwicklung, um eine vollständige Ablösung des Photolackes zu erreichen.

Eine zusätzliche Bestrahlung der gesamten Lackschicht vor der endgültigen Ablösung gestattet es, mit milderen Bedingungen zu arbeiten, da die Bestrahlung die Löslichkeit des Photolackes vergrössert. Dadurch wird das Risiko der Beschädigung des geätzten Metallmusters verkleinert.

Geeignete Lösungsmittel oder Lösungen für die endgültige Entfernung des Photolackes sind beispielsweise ein- bis zehnprozentige wässrige Lösungen von Natrium- oder Kaliumhydroxid bzw. -carbonat, sowie p-Toluolsulfonsäure, Milchsäure, Glykolsäure oder Essigsäure oder Lösungsmittel, wie Cyclohexanon, 2-Ethoxyethanol, Toluol, Aceton, Dimethylformamid, Dimethylacetamid oder Dimethylsulfoxid, sowie deren Mischungen.

Benutzt man zur galvanischen Abscheidung des Photolackes ein metallkaschiertes Laminat, so handelt es sich bei diesem Substrat beispielsweise um eine flache Platte, die einen Kern aus synthetischem Harz enthält, wobei dieses Harz gegebenenfalls faserverstärkt sein kann und wobei diese Fasern verwoben oder nicht verwoben sein können. Dieser Kern ist auf einer Seite oder auf beiden Seiten mit einem Metall kaschiert, bevorzugt mit Aluminium oder mit Kupfer.

Solche Laminate besitzen gegebenenfalls Oeffnungen im Harzkern, die durch metallische Verbindungen zwischen beiden Seiten der Platte ausgekleidet sind.

Wenn ein Laminat mit solchen Oeffnungen verwendet wird, so geschieht die bildmässige Belichtung des galvanisch abgeschiedenen Photolackes in der Weise, dass die Stellen über den Oeffnungen im Substrat unbelichtet bleiben. Das erreicht man in der Regel dadurch, dass die Oeffnungen durch die undurchlässigen Stellen der Photomaske abgedeckt werden.

Die aktinische Strahlung, mit der die positiv-arbeitenden Photolacke im erfindungsgemässen Verfahren belichtet werden, besitzt vorzugsweise eine Wellenlänge von 200 nm bis 600 nm. Als Strahlungsquellen kommen dabei vorzugsweise Kohlebogenlampen, Quecksilberdampflampen, Leuchtstofflampen mit UV-Licht emittierenden Leuchtstoffen, Argon- oder Xenon-Glühentladungslampen, Wolframfadenlampen oder Lampen für photographisches Flutlicht in Frage.

Von diesen Strahlungsquellen sind besonders Quecksilberdampflampen, insbesondere solche, die das Sonnenspektrum emittieren, bevorzugt; ferner werden Leuchtstofflampen oder Metallhalogenlampen bevorzugt.

Die Belichtungszeit hängt von einer Vielzahl von Faktoren ab; dazu zählen beispielsweise die individuellen Komponenten, die im Photolack verwendet werden, der Anteil dieser Komponenten im Lack, die Art der Strahlungsquelle, deren Abstand vom beschichteten Substrat.

Die optimalen Arbeitsbedingungen können wiederum vom Fachmann anhand von Routinetests leicht ermittelt werden.

Die Aetzlösungen, die zur Entfernung von Metallschichten zur Erzeugung eines Musters benötigt werden, sind bekannt. Je nach der Art der abzutragenden Metalloberfläche stehen unterschiedliche Aetzmittel zur Verfügung. Beispielsweise verwendet man für das Aetzen von Kupferoberflächen Ammoniumpersulfat oder FeCl₃ (als wässrige Lösungen).

In den folgenden Beispielen sind Mengenangaben, wie Teile oder Prozente, auf das Gewicht bezogen.

Die in den folgenden Beispielen verwendeten Harze werden wie folgt hergestellt:

### Harz 1

100,6 g o-Nitrobenzaldehyd, 192 g 1,4-Bis-(hydroxymethyl)-cyclohexan und 0,2 g p-Toluolsulfonsäure werden in 600 ml Dichlormethan gelöst und in einem Reaktionskolben in einer Stickstoffatmosphäre unter Rückfluss gekocht.

Das gebildete Wasser wird mit Hilfe einer Dean/Stark Falle entfernt; wenn sich kein weiteres Wasser mehr bildet, wird das Lösungsmittel abdestilliert. Die Mischung wird anschliessend für 16 Stunden bei 140°C gerührt; anschliessend werden flüchtige Bestandteile bei 140°C unter Anlegen eines Vakuums von 21 mbar abgezogen. Der Rückstand wird abkühlen gelassen und mit 140 g Xylol verdünnt. Man erhält eine Lösung mit einem Feststoffgehalt von 66 %.

Das Produkt ist eine Mischung, deren überwiegender Anteil ein Acetal der Formel I ist, worin R¹ ein 1,4-Cyclohexylenrest ist, und worin m 0 ist und n 1 bedeutet.

63,9 g der in der oben beschriebenen Reaktion erhaltenen Lösung werden mit 19,2 g Trimellitsäureanhydrid unter Rückfluss gerührt. Das Reaktionswasser wird mittels einer Dean/Stark Falle kontinuierlich entfernt.

Nach 3 Stunden hat sich der Säurewert der Reaktionsmischung auf 1,20 Aequivalente/kg erniedrigt; dann wird ein Vakuum angelegt und das Xylol abgezogen.

Der Rückstand wird in eine Al-Schale gegossen; man erhält eine dunkelgrüne feste Masse, die bei 90°C erweicht.

Diese Masse wird pulverisiert. Das so hergestellte Harz 1 besitzt wiederkehrende Struktureinheiten der Formel III, worin R¹ 1,4-Cyclohexylen ist, R³ 1,2-Phenylen-4-carbonsäure bedeutet und worin m 0 ist und n 1 bedeutet.

### Harz 2

13,4 g o-Nitrobenzylacrylat, 4,3 g Methylmethacrylat und 1,55 g Acrylsäure werden in 21,6 g Ethylacetat gelöst und 0.21 g Azo-bis-(isobutyronitril) zugegeben.

Die Mischung wird unter Stickstoff gehalten und bis zum Rückfluss erhitzt Nach 23 Stunden werden weitere 0,21 g Azo-bis-(isobutyronitril) zugegeben und der Rückfluss für weitere 6 Stunden aufrecht erhalten.

Die Mischung wird auf Raumtemperatur abgekühlt und zu einem Ueberschuss von Methanol getropft. Es fällt ein weisses gallertiges Produkt aus. Die obere Methanolschicht wird abdekantiert.

Das ausgefallene Produkt wird mit Trockeneis vermahlen und das erhaltene flockige Produkt wird anschliessend bei 40°C im Vakuum getrocknet. Es fallen 14 g eines weissen Pulvers an mit einem Säurewert von 0,84 Aequivalenten/kg.

Dieses Harz 2 ist ein Copolymer bestehend aus 60 % Resten der Formel IV, worin R⁴ Wasserstoff ist und A einen Benzolring bedeutet, und enthaltend 5 % freie Carboxylgruppen, die sich von Acrylsäure ableiten.

### Harz 3

Das Acetal der Formel I, worin R Wasserstoff ist, R¹ 1,4-Cyclohexylen bedeutet und n t ist, wird als 66 %ige Lösung in Xylol hergestellt, wie bei der Herstellung von Harz 1 beschrieben.

63,9 g dieser Lösung werden mit 14,4 g Trimellitsäureanhydrid und mit 3,7 g Phthalsäureanhydrid gemischt. Die Mischung wird unter Rückfluss erhitzt und das gebildete Reaktionswasser mit Hilfe einer Dean/Stark Falle entfernt. Nach 6 Stunden ist der Säurewert der Reaktionsmischung auf 0,88 Aequivalente/kg gefallen. Es wird nun ein Vakuum angelegt und das Xylol abgezogen. Der Rückstand wird in eine Al-Schale gegossen und abkühlen gelassen. Man erhält einen dunkelgrünen Feststoff, der bei 65°C erweicht. Dieser Feststoff wird zu einem Pulver vermahlen. Das auf diese Weise erhaltene Harz 3 besitzt wiederkehrende Struktureinheiten der Formel III, worin R¹ 1,4-Cyclohexylen ist, m 0 bedeutet, n 1 ist und R³ 1,2-Phenylen (in 25 % der Struktureinheiten) oder 1,2-Phenylen-4-carbonsäure (in 75 % der Struktureinheiten) darstellt.

### Harz 4

30,2 g o-Nitrobenzaldehyd, 28,8 g 1,4-Bis-(hydroxymethyl)-cyclohexan und 0,032 g p-Toluolsulfonsäure werden in 100 ml Toluol gelöst und in einer Stickstoffatmosphäre 46 Stunden lang unter Rückfluss erhitzt.

Das gebildete Reaktionswasser wird mittels einer Dean/Stark Falle entfernt. Anschliessend wird das Toluol im Vakuum abgezogen und der Rückstand 3 Stunden bei 180°C belassen.

Das Reaktionsprodukt wird in eine Al-Schale gegossen und abkühlen gelassen. Man erhält 50 g eines dunkelbraunen spröden Feststoffes der zu einem Pulver vermahlen wird. Dieses Pulver ist eine Mischung von Acetalen der Formel I, worin R¹ 1,4-Cyclohexylen ist, m 0 bedeutet und n eine ganze Zahl ist, deren Mittelwert 13 beträgt.

20 g dieses Pulvers werden in 7 g Xylol gelöst und 3,8 g Trimellitsäureanhydrid werden zugegeben. Die Mischung wird während 5 Stunden unter Rückfluss erhitzt. Innerhalb dieser Zeit fällt der Säurewert der Mischung auf 0,82 Aequivalente/kg.

Anschliessend wird das Xylol im Vakuum abgezogen und man erhält Harz 4.

Dieses Harz besitzt wiederkehrende Struktureinheiten der Formel III, worin R¹ 1,4-Cyclohexylen bedeutet, R³ 1,2-Phenylen-4-carbonsäure darstellt, m 0 ist und n eine ganze Zahl bedeutet, deren Mittelwert 13 beträgt.

### Harz 5

Ein Novolak, der durch Umsetzung von 3 Molen Phenol, 1 Mol p-tert.Butylphenol und Formaldehyd hergestellt wurde, wird mit 1,2-Naphthochinon-2-diazid-5-sulfonylchlorid umgesetzt, bis 12 % der freien Hydroxygruppen des Novolaks verestert sind.

10 g des auf diese Weise hergestellten Harzes werden in 50 g 2-Butoxyethanol gelöst und auf 50°C erhitzt. Zu dieser Lösung gibt man eine Lösung von 0,45 g Sarcosin, 0,33 g Paraformaldehyd (enthaltend 91 % Formaldehyd), 1 g 20 %iger wässriger Natronlauge und 10 g 2-Butoxyethanol. Die Temperatur dieser Reaktionslösung wird 2 Stunden bei 50°C belassen.

Anschliessend kühlt man ab, verdünnt mit 1 Liter Wasser und fällt das Produkt durch Zugabe von 10 ml 1 N Salzsäure. Der Niederschlag wird gewaschen, getrocknet und eine Portion von 4 g dieses Stoffes wird langsam zu einer Mischung von 4 g 2-Butoxyethanol und 0,5 g 20 %iger Natronlauge gegeben. Man erhält eine rotbraune Lösung. Anschliessend fügt man solange Wasser zu, bis eine 10 %ige Lösung von Harz 5 entstanden ist.

Dieses Harz besitzt im Mittel 9 wiederkehrende Struktureinheiten der Formel V. in denen R⁵ 4-tert.Butyl darstellt, p einen Mittelwert von 0.25 besitzt, R⁶ Wasserstoff ist, R⁷ in 88 % der Einheiten Wasserstoff bedeutet und in 12 % der Einheiten 1,2-Naphthochinon-2-diazid-5-sulfonyl ist, worin R⁸ eine Gruppe -CH₂-N(CH₃)-CH₂-COOH ist und q so gewählt ist, dass 8 % der wiederkehrenden Struktureinheiten der Formel V Reste R⁸ aufweisen.

### Harz 6

Man stellt eine Lösung bestehend aus 50 g 2-Butoxyethanol und 10 g des Novolak-1,2-naphthochinon-2-diazid-5-sulfonylester-Zwischenproduktester wie bei der Herstellung von Harz 5 beschrieben. Zu dieser Lösung gibt man eine Lösung aus 0.89 g Sarcosin, 0,66 g Paraformaldehyd (enthaltend 91 % Formaldehyd), 2 g 20 %iger wässriger Natronlauge und 10 g 2-Butoxyethanol. Das Gemisch wird auf 50°C erwärmt. Nach 2 Stunden bei 80°C wird das Gemisch abgekühlt, mit 500 ml Wasser verdünnt und das Produkt durch Ansäuern mit 1 N Salzsäure auf einen pH-Wert von 2,5 ausgefällt. Der Niederschlag wird filtriert, mit Wasser gewaschen und im Vakuumschrank bei 35°C getrocknet. Man erhält 10 g eines Produktes.

4 g davon werden langsam zu einer Mischung aus 4 g 2-Butoxyethanol und 0,5 g 20 %iger wässriger Kalilauge gegeben. Es entsteht eine klare rotbraune Lösung von Harz 6. Dieses Harz besitzt im Mittel 9 wiederkehrende Struktureinheiten der Formel V. worin R⁵ 4-tert.Butyl ist, p einen Mittelwert von 0,25 darstellt, R⁶ Wasserstoff ist, R⁷ in 88 % der Einheiten Wasserstoff ist und in den restlichen 12 % der Einheiten 1,2-Naphthochinon-2-diazid-5-sulfonyl darstellt, worin R⁸ eine Gruppe -CH₂-N(CH₃)-CH₂-COOH ist, und worin q so ausgewählt ist, dass 15 % der wiederkehrenden Struktureinheiten der Formel V Reste R⁸ besitzen.

### Harz 7

Man bereitet einen Novolak, indem man 3 Mole Phenol, 1 Mol p-tert.Butylphenol und 12 g Formaldehyd miteinander umsetzt. Dieser wird in 50 g 2-Butoxyethanol auflöst und diese Verbindungen mit 2,1 g Diethanolamin, 2,4 g Formalinlösung (HCHO-Gehalt: 38,3 %) und 2,1 g Milchsäurelösung (15 %ig) versetzt. Die Mischung wird für 3 Stunden auf 80°C erwärmt, mit 1 Liter Wasser verdünnt, auf einen pH-Wert von 6 eingestellt und filtriert.

Der Niederschlag wird mit Wasser gewaschen und in einem Vakuumtrockenschrank bei 35°C getrocknet. Man erhält 12 g einer Novolak-Mannichbase mit Diethanolamin.

Dieses Produkt wird in 40 g Aceton gelöst und 3 g 1,2-Naphthochinon-2-diazid-5-sulfonylchlorid (gelöst in 20 g Aceton) werden zugegeben. Anschliessend wird die Mischung mit 5 %iger wässriger Natriumcarbonatlösung auf einen pH-Wert von 8 abgepuffert.

Die Mischung wird 1 Stunde lang bei Raumtemperatur gerührt und anschliessend mit 1/10 N-Salzsäure auf einen pH-Wert von 3 eingestellt. Man erhält eine klare Lösung.

Dann gibt man wässrige Natronlauge zu, bis ein pH-Wert von 6 erreicht ist und filtriert den entstandenen Niederschlag ab. Das Produkt wird in einem Vakuumtrockenschrank bei 35°C getrocknet.

4 g dieses Produktes werden in 4 g 2-Butoxyethanol gelöst und mit 32 g Wasser verdünnt. Auf diese Weise erhält man eine 10 %ige Lösung von Harz 7, das im Mittel 9,5 wiederkehrende Struktureinheiten der Formel V besitzt, worin R⁵ 4-tert.Butyl bedeutet, p einen Mittelwert von 0,25 besitzt, R⁶ Wasserstoff ist, R⁷ in 89 % der Einheiten Wasserstoff darstellt und in den restlichen 11 % der Einheiten eine 1,2-Naphthochinon-2-diazid-5-sulfonylgruppe ist, worin R⁸ eine Gruppe -CH₂-N(CH₂-CH₂-OH)₂ ist, und worin q so gewählt ist, dass 20 % der wiederkehrenden Struktureinheiten der Formel V Reste der Formel R⁸ besitzen.

### Harz 8

Man stellt einen Novolak her, indem man Phenol, p-tert.Butylphenol, das Kaliumsalz von Hydrochinonsulfonsäure und Formaldehyd (als Formalin enthaltend 38,8 % Formaldehyd) im molaren Verhältnis 0,75 : 0,25 : 0,1 : 0,88 erhitzt. Nachdem alle flüchtigen Bestandteile abdestilliert sind, erhält man ein Harz mit einem Erweichungspunkt von 146°C.

18 g dieses Novolaks werden in 50 g Aceton gelöst und mit einer Lösung von 6 g 1,2-Naphthochinon-2-diazid-5-sulfonylchlorid in 20 g Aceton versetzt. Die Mischung wird mit 10 %iger wässriger Natriumcarbonatlösung auf einen pH-Wert von 8 eingestellt und 1 Stunde bei Raumtemperatur gerührt. Anschliessend tropft man das Reaktionsgemisch zu 2,5 Litern 0,2 N-Salzsäure, filtriert den ausgefallenen Niederschlag ab, wäscht mit Wasser und trocknet bei 35°C im Vakuumtrockenschrank. Man erhält so 18 g des Harzes 8, das im Mittel 7,3 der wiederkehrenden Struktureinheiten der Formel V enthält, worin (R⁵)ₚ in 23 % der Einheiten p-tert.Butyl bedeutet, in 9 % der Einheiten p-Hydroxyl ist und worin p in den verbleibenden 68 % der Einheiten 0 ist, worin R⁶ Wasserstoff ist, R⁷ in 10 % der Einheiten 1,2-Naphthochinon-2-diazid-5-sulfonyl ist und in den restlichen 90 % Wasserstoff bedeutet, und worin (R⁸)_{q} in 9 % der Einheiten eine Sulfonsäuregruppe ist.

### Harz 9

Man stellt einen Novolak her, indem man Phenol, 4-tert.Butylphenol, 4,4-Bis-(4-hydroxyphenyl)-pentansäure und Formaldehyd (als 38 %ige Formalinlösung) sowie Oxalsäure als Katalysator in einem molaren Verhältnis von 0,75 : 0,25 : 0,1: 0,99 : 0,016 miteinender erhitzt.

Flüchtige Bestandteile werden durch Destillation abgetrennt und man erhält einen Novolak mit einem Erweichungspunkt von 119°C.

18 g dieses Novolaks werden in 50 g Aceton gelöst und mit einer Lösung von 6 g 1,2-Naphthochinon-2-diazid-5-sulfonylchlorid in 20 g Aceton versetzt. Die Reaktionsmischung wird durch Zugabe von 10 %iger wässriger Natriumcarbonatlösung auf einen pH-Wert von 8 eingestellt und dann eine Stunde lang bei Raumtemperatur gerührt.

Dann gibt man diese Lösung tropfenweise in 2,5 Liter 0,2 N-Salzsäure, filtriert das ausgefallene Produkt ab, wäscht es mit Wasser und trocknet es in einem Vakuumtrockenschrank bei 35°C. Man erhält 9 g von Harz 9; dies ist ein Novolak, der im Mittel 5,8 der wiederkehrenden Struktureinheiten der Formel V besitzt, worin (R⁵)ₚ in 23 % der Einheiten p-tert.Butyl bedeutet, in 9 % der Einheiten ein Rest der Formel VI ist und worin in den verbleibenden 68 % der Einheiten p 0 bedeutet, worin R⁶ Wasserstoff ist, worin R⁷ in Formel V und (R⁷)ᵣ in Formel VI zusammen zu 9 % 1,2-Naphthochinon-2-diazid-5-sulfonylgruppen sind und die restlichen 91 % Wasserstoff bedeuten, worin q und s 0 sind und worin Z eine Gruppe -(C(CH₃)-CH₂-CH₂-COOH]- ist.

### Harz 10

Man stellt einen Novolak her, indem man Phenol, p-tert.Butylphenol, p-Hydroxybenzoesäure, Formaldehyd (als 38,8 %ige Formalinlösung) und Oxalsäure in einem molaren Verhältnis von 0,5 : 0,5 : 0,2 : 1,08 : 0,016 miteinander erhitzt.

Nach Abdestillieren aller flüchtiger Bestandteile wird ein Harz mit einem Erweichungspunkt von 120°C erhalten. 18 g dieses Novolaks werden in 50 g Aceton gelöst und mit einer Lösung aus 6 g 1,2-Naphthochinon-2-diazid-5-sulfonylchlorid in 20 g Aceton behandelt. Die Mischung wird durch Zugabe einer 10 %igen wässrigen Natriumcarbonatlösung auf einen pH-Wert von 8 eingestellt und dann eine Stunde lang bei Raumtemperatur gerührt.

Anschliessend gibt man dieses Reaktionksgemisch tropfenweise zu 2,5 Litern 0,2 N-Salzsäure, filtriert den ausgefallenen Niederschlag ab. wäscht mit Wasser und trocknet bei 35°C im Vakuumtrockenschrank.

Man erhält so 18,5 g von Harz 10; dieses ist ein Novolak enthaltend im Mittel 6,1 der wiederkehrenden Struktureinheiten der Formel V, worin (R⁵)ₚ in 42 % der Einheiten p-tert.Butyl ist und worin p in den verbleibenden 58 % der Einheiten 0 bedeutet, worin R⁶ Wasserstoff ist, R⁷ in 10 % der Einheiten 1,2-Naphthochinon-2-diazid-5-sulfonyl ist und in den verbleibenden 90 % der Einheiten Wasserstoff bedeutet, worin (R⁸)_{q} in 16 % der Einheiten 4-Carbonsäure ist und worin in den verbleibenden 85 % der Einheiten q 0 ist.

### Harz 11

Man stellt einen Novolak her, indem man 3 Mole Phenol, 1 Mol p-tert.Butylphenol und 36 g Formaldehyd miteinander umsetzt. Diesen Novolak löst man in 36 g 2-Butoxyethanol auf und gibt zu dieser Lösung 13,8 g Thioglykolsäure und 14,9 g Paraformaldehyd (enthaltend 91 % Formaldehyd). Die Mischung wird 2 Stunden lang auf 140°C erhitzt. Dann wird ein Vakuum angelegt und auf 180°C erhitzt, um alle flüchtigen Bestandteile zu entfernen.

18 g dieses Produktes werden in 40 g Aceton gelöst und eine Lösung von 6 g 1,2-Naphthochinon-2-diazid-5-sulfonylchlorid in 20 g Aceton wird zugegeben. Die Mischung wird mittels 56 g einer 10 %igen wässrigen Natriumcarbonatlösung auf einen pH-Wert von 8 eingestellt und bei Raumtemperatur für 1 Stunde gerührt. Anschliessend gibt man tropfenweise 2 Liter 2 N-Salzsäure zu, filtriert den gelben harzigen Niederschlag ab, wäscht mit Wasser und trocknet. Das Produkt (18,8 g)ist Harz 11 und enthält im Mittel 9,5 der wiederkehrenden Struktureinheiten der Formel V, worin R⁵ 4-tert.Butyl ist, p einen Mittelwert von 0,25 aufweist, R⁶ Wasserstoff ist, R⁷ in 82 % der Einheiten Wasserstoff ist und in den verbleibenden 18 % der Einheiten 1,2-Naphthochinon-2-diazid-5-sulfonyl ist, worin R⁸ eine Gruppe -CH²-S-CH²-COOH ist und worin q so ausgewählt ist, dass 50 % der wiederkehrenden Struktureinheiten der Formel V Gruppen R⁸ besitzen.

### Harz 12

13,8 g Harz 9 werden in 40 g 2-Butoxyethanol gelöst und auf 50°C erhitzt. Dazu gibt man eine Lösung aus 0,61 g Sarcosin, 0,46 g Paraformaldehyd (mit einem Formaldehydgehalt von 91 %), 1 g 20 %iger wässriger Natronlauge und 15 g 2-Butoxyethanol. Diese Mischung wird 2 Stunden lang bei 50°C gehalten.

Das Produkt trennt man durch Ausfällen in 0,13 N-Salzsäure ab. Der Niederschlag wird filtriert, gewaschen und getrocknet. Man erhält 13 g des Harzes 12; dieses besitzt im Mittel 5,8 der wiederkehrenden Struktureinheiten der Formel V, worin (R⁵)ₚ in 23 % der Einheiten p-tert.Butyl bedeutet, in 9 % der Einheiten eine Gruppe der Formel VI ist und worin in den verbleibenden 68 % der Einheiten p = 0 ist, worin R⁶ Wasserstoff ist, worin R⁷ in Formel V und (R⁷)ᵣ in Formel VI zu 9 % 1,2-Naphthochinon-2-diazid-5-sulfonyl sind und zu 91 % Wasserstoff bedeuten, worin R⁸ ein Rest -CH₂-N(CH₃)-CH₂-COOH ist, worin q und s so gewählt sind, dass 7 % der Gruppen der Formel V und der Formel VI Reste R⁸ besitzen und worin Z einen Rest der Formel -[C(CH₃)-CH₂-CH₂-COOH]- bedeutet.

Beispiel 1: 1 Teil von Harz 1 wird in 1 Teil 2-Butoxyethanol gelöst, mit Kaliumhydroxidlösung neutralisiert und mit Wasser verdünnt, so dass eine Endkonzentration von 10 % des Harzes 1 entsteht.

Das Harz wird nun auf einer kupferkaschierten Anode galvanisch abgeschieden, wobei als Kathode rostfreier Stahl verwendet wird. Bei einer Spannung von 40 V bildet sich innerhalb von 20 Sekunden ein 10 µm dicker Film auf der Anode.

Das Laminat wird aus dem Elektrolysebad entfernt, mit Wasser gespült und 10 Minuten bei 90°C getrocknet.

Anschliessend wird es 2 Minuten lang unter einer Photomaske (Diapositiv) bestrahlt. Es wird eine 5000 W Mitteldruck-Quecksilber Lampe verwendet. Die Entfernung zwischen Lampe und zu belichtender Schicht beträgt 75 cm.

Nach der Belichtung wird die Platte in 2 %ige wässrige Natriumhydroxidlösung getaucht und entwickelt.

Man erhält ein klares positives Bild der Maskenstrukturen.

Das auf diese Weise freigelegte Kupfer wird mittels FeCl₃ weggeätzt. Dazu wird die Platte in eine 40 %ige wässrige FeCl₃-Lösung getaucht. Die Aetztemperatur beträgt 30°C. Anschliessend wird die Platte mit Wasser gewaschen und getrocknet.

In einem weiteren Arbeitsgang wird die Platte ohne Photomaske mittels der Quecksilberlampe 2 Minuten lang belichtet.

Nach 45 Sekunden Entwicklungsdauer in 2 %iger wässriger Natriumhydroxidlösung wird das restliche Harz vollständig abgelöst und man erhält ein klares positives Kupferbild der Photomaske auf dem Laminat.

Beispiel 2: 8 Teile des Harzes 2 werden in 10 Teilen einer 2 : 1 Mischung von 2-Butoxyethanol und 2-Ethoxyethylacetat gelöst. Man erhält eine klare Lösung, die mit 20 %iger wässriger Kaliumhydroxidlösung neutralisiert wird. Anschliessend wird Wasser zugefügt, bis eine 10 %ige Harzlösung mit einem pH-Wert von 7 entstanden ist.

Das Harz wird auf einem kupferkaschierten Laminat galvanisch abgeschieden, wobei als Kathode rostfreier Stahl verwendet wird.

Innerhalb von 10 Sekunden bildet sich bei 10 V ein 24 µm dicker Harzfilm. Die beschichtete Platte wird mit Wasser gespült und 10 Minuten lang bei 90°C getrocknet. Der Ueberzug wird anschliessend 2 Minuten lang unter einer Photomaske (Diapositiv) belichtet, wobei man eine 5000 W Mitteldruck-Quecksilber Lampe verwendet und einen Abstand zwischen Lampe und Substrat von 75 cm einhält.

Die belichtete Platte wird durch Aufstreichen von 5 %iger wässriger Natriumhydroxidlösung entwickelt und ein klares positives Bild der Photomaske entsteht.

Das freigelegte Kupfer wird mit FeCl₃ entfernt. Dazu wird die Platte bei 30°C in eine 40 %ige wässrige Lösung von FeCl₃ getaucht, anschliessend mit Wasser gespült und getrocknet.

Danach wird die Platte ohne Photomaske nochmals in der oben beschriebenen Weise belichtet. Die Belichtungsdauer beträgt 5 Minuten.

Der restliche Harzfilm wird dann durch Eintauchen in eine 5 %ige wässrige Natriumhydroxidlösung vollständig entfernt. Zurück bleibt ein klares positives Kupferbild der Photomaske auf dem Laminat.

Beispiel 3: Gleiche Teile von Harz 3 und 2-Butoxyethanol werden vermischt. Es entsteht eine Lösung. Diese wird mit wässriger Kaliumhydroxidlösung neutralisiert und mit Wasser auf eine Endkonzentration des Harzes von 10 % verdünnt.

Das Harz wird auf einem kupferkaschierten Laminat anodisch abgeschieden. Als Kathode verwendet man rostfreien Stahl. Innerhalb von 30 Sekunden bildet sich bei einer Spannung von 40 V ein Ueberzug von 11 µm Dicke. Das beschichtete Laminat wird mit Wasser gespült und 10 Minuten bei 90°C getrocknet.

Der abgeschiedene Harzfilm wird mit einer Photomaske bedeckt und 8 Minuten lang mit einer 5000 W Mitteldruck-Quecksilber Lampe belichtet. Dabei beträgt der Abstand zwischen Substrat und Lampe 75 cm.

Es wird durch Aufstreichen einer 2 %igen wässrigen Natriumhydroxidlösung bei Raumtemperatur entwickelt und man erhält ein klares positives Bild der Photomaske.

Das freigelegte Kupfer wird weggeätzt. Dazu verwendet man eine 40 %ige wässrige FeCl₃ Lösung. Die Aetzung erfolgt bei 30°C. Anschliessend wird die Platte mit Wasser gewaschen und getrocknet.

In einem weiteren Arbeitsgang wird die Platte nochmals belichtet. Dabei wird allerdings keine Photomaske verwendet. Die Belichtungszeit beträgt 2 Minuten, sonst sind die Bedingungen dieselben, wie oben beschrieben.

Es wird 5 Minuten lang durch Bestreichen mit 2 %iger wässriger Natriumhydroxidlösung entwickelt und der restliche Harzfilm löst sich ab.

Man erhält ein klares positives Kupferbild der Photomaske auf dem Laminatträger.

Beispiel 4: Gleiche Teile von Harz 4 und von 2-Butoxyethanol werden ineinander gelöst und mit einer 20 %igen wässrigen Lösung von Kaliumhydroxid neutralisiert. Anschliessend fügt man Wasser hinzu, bis eine 10 %ige Harzlösung entstanden ist.

Das Harz wird auf einem kupferkaschierten Laminat anodisch abgeschieden. Als Kathode verwendet man rostfreien Stahl. Innerhalb von 20 Sekunden bildet sich bei einer Spannung von 40 V ein 21 µm dicker Harzfilm. Das beschichtete Laminat wird mit Wasser gespült und 10 Minuten bei 90°C getrocknet.

Diese Anordnung wird unter einer Photomaske 10 Minuten, wie oben beschrieben, belichtet. Bei Bestreichen mit 5 %iger wässriger Natriumhydroxidlösung entsteht ein klares positives Bild der Photomaske.

Das freigelegte Kupfer wird mit einer 40 %igen wässrigen FeCl₃ Lösung bei 30°C weggeätzt. Danach wird die Platte mit Wasser gewaschen und getrocknet.

In einem weiteren Arbeitsgang wird die Platte dann ohne Photomaske, wie oben beschrieben, belichtet. Die Belichtungsdauer beträgt 5 Minuten.

Es wird in 5 %ige wässrige Natriumhydroxidlösung getaucht. Dabei löst sich das restliche Harz vollständig ab und zurück bleibt ein klares positives Kupferbild auf dem Laminat.

Beispiel 5: 40 g einer 10 %igen Lösung von Harz 5 werden mit 5 g einer 10 %igen wässrigen Lösung von maleinisiertem Polybutadien gemischt.

Das Harz wird auf einem kupferkaschierten Laminat anodisch abgeschieden. Als Kathode verwendet man rostfreien Stahl. Innerhalb von 20 Sekunden bildet sich bei einer Spannung von 100 V ein Ueberzug von 11 µm Dicke. Das beschichtete Laminat wird mit Wasser gespült und 5 Minuten bei 90°C getrocknet.

Der abgeschiedene Harzfilm wird mit einer Photomaske bedeckt und 5 Minuten lang mit einer 5000 W Mitteldruck-Quecksilber Lampe belichtet. Dabei beträgt der Abstand zwischen Substrat und Lampe 75 cm.

Es wird durch Eintauchen in 2 %ige wässrige Natriumhydroxidlösung entwickelt und man erhält ein klares positives Bild der Photomaske.

Das freigelegte Kupfer wird weggeätzt. Dazu verwendet man eine 40 %ige wässrige FeCl₃ Lösung. Die Aetzung erfolgt bei 30°C. Anschliessend wird die Platte mit Wasser gewaschen und getrocknet.

In einem weiteren Arbeitsgang wird die Platte nochmals belichtet. Dabei wird allerdings keine Photomaske verwendet. Die Belichtungszeit beträgt 1 Minute, sonst sind die Bedingungen dieselben, wie oben beschrieben.

Es wird durch Eintauchen in 2 %ige wässrige Natriumhydroxidlösung entwickelt und der restliche Harzfilm löst sich vollständig ab.

Man erhält ein klares positives Kupferbild der Photomaske auf dem Laminatträger.

Beispiel 6: Beispiel 5 wird wiederholt. Dabei wird als Anode bei der galvanischen Abscheidung ein kupferkaschiertes Laminat verwendet, das plattierte durchgehende Löcher aufweist. Als Kathode verwendet man rostfreien Stahl. Nach 2 Minuten Galvanisierdauer bei 80 - 120 V bildet sich ein 17 µm dicker Harzfilm auf beiden Seiten der Anode. Das Harz schlägt sich auch an den Stellen der durchgehenden Löcher auf der Platte nieder.

Das beschichtete Laminat wird mit Wasser gespült und 5 Minuten bei 90°C getrocknet.

Beide Seiten des beschichteten Laminates werden durch Photomasken 30 Sekunden lang mit einer 5000 W Mitteldruck-Quecksilber Lampe belichtet. Dabei beträgt der Abstand zwischen Substrat und Lampe 75 cm.

Es wird durch Eintauschen in eine 2 %ige wässrige Natriumhydroxidlösung bei Raumtemperatur entwickelt und man erhält klare positive Bilder der Photomasken; die Masken sind so konstruiert. dass die Löcher auf dem Träger nicht belichtet werden und daher das Harz an diesen Stellen verbleibt.

Das freigelegte Kupfer wird weggeätzt. Dazu verwendet man eine 40 %ige wässrige FeCl₃ Lösung. Die Aetzung erfolgt bei 30°C. Anschliessend wird die Platte mit Wasser gewaschen und getrocknet.

In einem weiteren Arbeitsgang wird die Platte nochmals beidseitig belichtet. Dabei wird allerdings keine Photomaske verwendet. Die Belichtungszeit beträgt 1 Minute, sonst sind die Bedingungen dieselben, wie oben beschrieben.

Es wird durch Eintauchen in 2 %ige wässrige Natriumhydroxidlösung entwickelt und der restlilche Harzfilm löst sich vollständig ab.

Man erhält klare positive Kupferbilder der Photomaske auf beiden Seiten des Laminatträgers; das Kupfer an den durchgehenden Oeffnungen bleibt dabei beidseitig erhalten.

Beispiel 7: Die Lösung von Harz 6 wird mit Wasser auf einen Harzanteil von 10 % verdünnt und 40 g der resultierenden Lösung werden mit 5 g einer 10 %igen wässrigen Lösung eines anionischen Harzes gemischt, dass gemäss Beispiel 15 der US-PS 4,362,853 erhalten wurde. Diese Harzmischung wird auf einer kupferkaschierten Anode abgeschieden, wobei als Kathode rostfreier Stahl verwendet wird. Es bildet sich ein Film von 7µm Dicke nach 30 Sekunden bei 80 V.

Das beschichtete Laminat wird mit Wasser gewaschen und 5 Minuten lang bei 90°C getrocknet. Es wird anschliessend 2 Minuten lang durch eine Photomaske belichtet. Als Lichtquelle verwendet man eine 5000 W Mitteldruck-Quecksilberlampe in einer Entfernung von 75 cm von der Substratoberfläche.

Nach Entwicklung mit einer 2 %igen wässrigen Natriumhydroxidlösung erhält man ein klares positives Bild der Photomaske.

Beispiel 8: 40 g der Lösung von Harz 7 wird mit 4 g einer 10 %igen Lösung eines kationischen Polybutadienharzes vermischt. Die Harzlösung wird auf einer kupferkaschierten Kathode galvanisch abgeschieden. Als Anode verwendet man rostfreien Stahl. Bei einer Spannung von 10 V bildet sich innerhalb von 30 Sekunden ein Film von 5 µm Dicke.

Das beschichtete Laminat wird aus dem Galvanisierbad entfernt und bei 90°C für 5 Minuten getrocknet. Anschliessend bestrahlt man es durch eine Photomaske 1 Minute lang. Als Lichtquelle verwendet man eine 5000 W Mitteldruck Quecksilberlampe in einer Entfernung von 75 cm von der Substratoberfläche.

Nach Entwickeln durch Eintauchen in eine 2 %ige wässrige Natriumhydroxidlösung erhält man ein klares positives Bild der Photomaske.

Beispiel 9: 10 g des Harzes 8 werden in 10 g 2-Butoxyethanol gelöst, mit 1 N wässriger Kalilauge neutralilsiert und mit Wasser auf 100 g verdünnt. Das Harz wird auf einer kupferkaschierten Anode galvanisch abgeschieden, wobei eine Kathode aus rostfreiem Stahl verwendet wird. Bei einer Spannung von 80 V bildet sich innerhalb von 60 Sekunden ein 12 µm dicker Niederschlag.

Das beschichtete Laminat wird aus dem Bad entfernt, mit Wasser abgespült und 5 Minuten lang bei 90°C getrocknet. Es wird anschliessed 1 Minute lang durch eine Photomaske bestrahlt. Als Lichtquelle verwendet man eine 5000 W Mitteldruck Quecksilberlampe im Abstand von 75 cm von der Substratoberfläche.

Nach dem Entwickeln durch Eintauchen in eine 2 %ige wässrige Natriumhydroxidlösung erhält man ein klares positives Bild der Photomaske.

Beispiel 10: Beispiel 9 wird wiederholt, wobei jedoch das eingesetzte Harz durch die gleiche Menge Harz 9 ersetzt wird. Bei einer Spannung von 60 V bildet sich nach 60 Sekunden ein Niederschlag von 12 µm Dicke.

Nach dem Trocknen und Belichten, wie in Beispiel 9 beschrieben, erhält man ein klares positives Bild der Photomaske auf dem Laminat.

Das freigelegte Kupfer wird weggeätzt. Dazu verwendet man eine 40 %ige wässrige FeCl₃ Lösung. Die Aetzung erfolgt bei 30°C. Anschliessend wird die Platte mit Wasser gewaschen und getrocknet.

In einem weiteren Arbeitsgang wird die Platte nochmals belichtet. Dabei wird allerdings keine Photomaske verwendet. Die Belichtungszeit beträgt 1 Minute, sonst sind die Bedingungen dieselben, wie oben beschrieben.

Es wird 30 Sekunden lang durch Eintauchen in 1 %ige wässrige Natriumhydroxidlösung entwickelt und der restliche Harzfilm löst sich vollständig ab.

Man erhält ein klares positives Kupferbild der Photomaske auf dem Laminatträger.

Beispiel 11: Beispiel 9 wird wiederholt, wobei jedoch das eingesetzte Harz durch Harz 10 ersetzt wird. Nach 60 Sekunden bei 75 V bildet sich ein Niederschlag von 8 µm Dicke. Nach Belichtung und anschliessender Entwicklung, wie in Beispiel 9 beschrieben, erhält man ein klares positives Bild der Photomaske auf dem Laminat.

Beispiel 12: Beispiel 5 wird wiederholt. Dabei wird jedoch auf das maleinierte Polybutadien verzichtet. Nach 20 Sekunden bildet sich bei einer Spannung von 40 V ein Niederschlag von 29 µm Dicke. Dieser Niederschlag wird durch eine Photomaske belichtet und anschliessend entwickelt, wie in Beispiel 5 beschrieben. Man erhält ein klares positives Bild der Photomaske auf der Kupferoberfläche, Entfernen des freigelegten Kupfers durch Abaetzen mit FeCl₃-Lösung und endgültiges Ablösen des restlichen Harzfilmes durch nochmaliges Belichten und anschliessendes Eintauchen in 2 %ige Natriumhydroxidlösung führt zu einem klaren positiven Kupferbild der Photomaske auf dem Laminat.

Beispiel 13: 1 Teil Harz 11 wird in 1 Teil 2-Butoxyethanol gelöst und mit 20 %iger wässriger Natriumhydroxidlösung neutralisiert. Anschliessend fügt man Wasser zu, bis eine 10 %ige Harzlösung entstanden ist.

Das Harz wird auf einem kupferkaschierten Laminat anodisch abgeschieden. Als Kathode verwendet man rostfreien Stahl. Innerhalb von 60 Sekunden bildet sich bei einer Spannung von 80 V ein Ueberzug von 2 µm Dicke. Das beschichtete Laminat wird mit Wasser gespült und 5 Minuten bei 90°C getrocknet.

Der abgeschiedene Harzfilm wird mit einer Photomaske bedeckt und 1 Minute lang mit einer 5000 W Mitteldruck-Quecksilber Lampe belichtet. Dabei beträgt der Abstand zwischen Substrat und Lampe 75 cm.

Es wird durch Eintauchen in 2 %ige wässrige Natriumhydroxidlösung entwickelt und man erhält ein klares positives Bild der Photomaske auf der Kupferoberfläche.

Beispiel 14: Beispiel 13 wird wiederholt, wobei jedoch Harz 11 durch Harz 12 ersetzt wird. Nach 60 Sekunden bei einer Spannung von 30 V bildet sich ein Niederschlag von 3 µm Dicke. Das beschichtete Laminat wird wie in Beispiel 13 beschrieben belichtet, und das Bild durch Behandlung mit 1 %iger wässriger Natriumhydroxidlösung entwickelt. Es bildet sich ein klares positives Bild.

## Patentansprüche

1. Verfahren zur Herstellung metallischer Abbildungen auf der Metalloberfläche eines metallkaschierten Laminates, wobei besagtes Verfahren folgende Arbeitsschritte enthält:
a) galvanische Abscheidung einer Schicht eines positiv arbeitenden Photolackes, der sowohl salzbildende Gruppen als auch photoempfindliche Gruppen im gleichen Polymermolekül enthält, auf das metallkaschierte Laminat wobei eine einheitliche Bedeckung aus besagtem positiv arbeitenden Photolack entsteht,
b) Belichtung der aufgebrachten Schicht durch ein vorbestimmtes Muster aktinischer Strahlung, wodurch die der Strahlung ausgesetzten Stellen der aufgebrachten Schicht gegenüber einem Entwicklungsmittel löslicher werden als die unbestrahlten Stellen,
c) Entfernen der aufgebrachten Schicht von den belichteten Stellen durch Kontakt mit einem Entwickler,
d) Enffernen der freigelegten Metalloberfläche mittels eines geeigneten Aetzmittels und
e) Entfernen des restlichen positiv arbeitenden Photolackes durch Kontakt mit einem geeigneten Lösungsmittel.

2. Verfahren gemäss Anspruch 1, umfassend zusätzlich vor der letzten Verfahrensstufe e) einen weiteren Schritt d1), wobei das Laminat aktinischer Strahlung ausgesetzt wird, so dass der restliche positiv arbeitende Photolack in einen löslicheren Zustand übergeführt wird.

3. Verfahren gemäss Anspruch 1, wobei das Laminat beidseitig metallbeschichtet ist und Oeffnungen enthält, die ihrerseits mit Metall belegt sind.

4. Verfahren gemäss Anspruch 1, worin der positiv arbeitende Photolack eine Verbindung der Formel I oder II ist 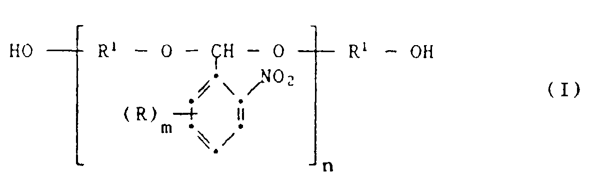 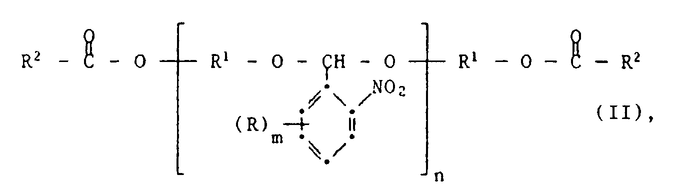 oder eine Verbindung ist enthaltend die wiederkehrende Struktureinheit der Formel III 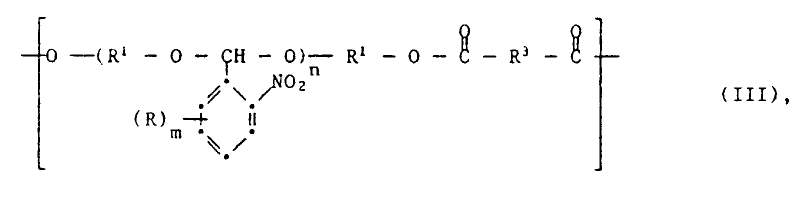 worin
m 0 ist oder eine ganze Zahl von 1 bis 4 bedeutet,
n eine ganze Zahl von 1 bis 20 bedeutet,
R Alkyl, Alkoxy, Nitro, Amino oder Carboxyl ist, wobei die Reste R im Falle m >1 im Rahmen der gegebenen Definition unterschiedliche Bedeutungen besitzen können, worin
R¹ ein divalenter organischer Rest ist, der gegebenenfalls mit einer Amino- oder Carboxylgruppe substituiert sein kann, worin
R² ein monovalenter organischer Rest ist, der gegebenenfalls mit einer Amino- oder Carboxylgruppe substituiert ist, und worin
R³ ein divalenter organischer Rest ist, der gegebenenfalls mit einer Amino- oder Carboxylgruppe substituiert ist, mit der Massgabe, dass wenigstens eine der Gruppen R, R¹, R² oder R³ eine Amino- oder Carboxylgruppe enthält.

5. Verfahren gemäss Anspruch 4, worin R¹ C₅-C₁₅Alkylen, lineares durch ein oder mehrere Heteroatome oder -gruppen unterbrochenes C₄-C₁₅ Alkylen oder lineares, durch eine C₅-C₇Cycloalkylengruppe unterbrochenes C₂-C₆Alkylen bedeutet, wobei jeder dieser Reste durch eine Amino- oder Carboxylgruppe substituiert sein kann, und worin R³ C₂-C₁₅Alkylen oder C₆-C₁₀Arylen darstellt, wobei diese Reste gegebenenfalls durch eine Aminogruppe oder einen Carboxylrest substituiert sind.

6. Verfahren gemäss Anspruch 1, worin der positiv arbeitende Photolack ein Copolymeres ist mit einem Molekulargewicht von mindestens 500, wobei als Comonomere o-Nitrocarbinolester einer ungesättigten Carbonsäure und einer ungesättigten freien Carbonsäure verwendet werden, und wobei mindestens 5 % vom Gesamtmolekül, bezogen auf das Molekulargewicht, aromatisch-carbozyklische oder aromatisch-heterozyklische o-Nitrocarbinolestergruppen der Formel IV enthalten 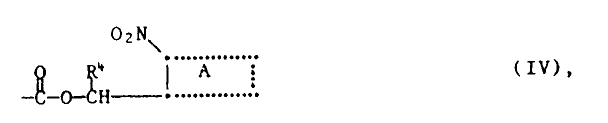 worin A einen aromatisch-carbozyklischen oder aromatisch-heterozyklischen Ring bedeutet, der gegebenenfalls substituiert sein kann und 5 bis 14 Glieder umfasst, worin R⁴ Wasserstoff, C₁-C₈Alkyl oder eine gegebenenfalls substituierte Aryl- oder Aralkylgruppe bedeutet, wobei die gegebenenfalls an A oder R⁴ vorhandenen Substituenten C₁-C₈Alkyl- oder -Alkoxyreste sind, oder Halogen, Nitro, Amino oder Carboxyl bedeuten.

7. Verfahren gemäss Anspruch 1, worin der positiv arbeitende Photolack ein Chinondiazidsulfonylester eines phenolischen Novolakes ist, der wenigstens zwei der wiederkehrenden Struktureinheiten der Formel V enthält 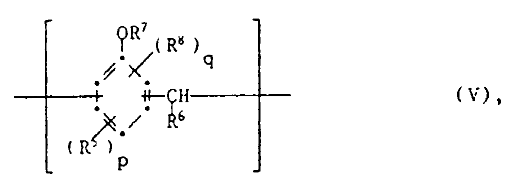 worin R⁵ Halogen, Hydroxy oder Alkoxy ist, oder eine gegebenenfalls veresterte Carbonsäure- oder Sulfonsäuregruppe darstellt, oder gegebenenfalls durch eine Carboxylgruppe substituiertes Alkyl, Alkenyl oder Aryl bedeutet, oder worin R⁵ ein Rest der Formel -NR⁹R¹⁰, -COR¹¹ , -OCOR¹² , -OSO₂R¹² oder -OSO₂R¹³ ist, oder worin einer der Reste R⁵ eine Gruppe der Formel VI ist 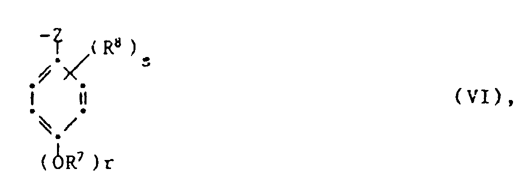 wobei besagte Gruppe der Formel VI mit benachbarten aromatischen Ringen durch Reste der Formel -CHR⁶- verbunden sein kann, worin p 0, 1, 2 oder 3 ist, r 0 oder 1 bedeutet und s 0 oder 1 darstellt, worin R⁵ Wasserstoff oder Alkyl, Aryl oder Carboxyl bedeutet, worin R⁷ Wasserstoff ist oder gegebenenfalls durch Hydroxy oder Alkoxy substituiertes Alkyl bedeutet, oder worin R⁷ eine Gruppe der Formel -SO₂R¹³, -SO₂R¹² oder -COR¹² ist, worin wenigstens 4 % der Reste R⁷ des Esters mit den wiederkehrenden Struktureinheiten der Formel V eine Gruppe der Formel -SO₂R¹³ darstellen, worin R⁸ eine salzbildende Gruppe ist, worin q 0 oder 1 ist, worin R⁹ Wasserstoff oder Alkyl bedeutet oder -COR¹² , -SO₂R¹² oder -SO₂R¹³ ist, worin R¹⁰ Wasserstoff oder Alkyl ist, R¹¹ ein monovalenter aliphatischer oder cycloaliphatischer Rest ist, R¹² einen monovalenten aliphatischen, cycloaliphatischen, aromatischen oder araliphatischen Rest bedeutet, worin R¹³ eine 1,2-Benzo- oder Naphthochinondiazidgruppe der Formel VII oder VIII ist 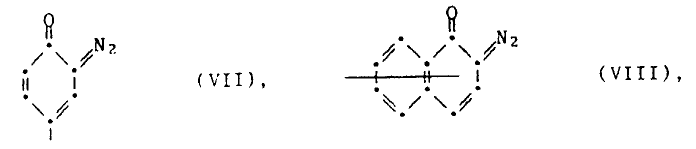 wobei die freie Valenz im Naphthochinon der Formel VIII sich in 4-oder 5-Position befindet, worin Z Sauerstoff, Schwefel, Carbonyl oder Sulfonyl bedeutet oder C₁-C₆Alkylen ist, das gegebenenfalls durch ein Halogenatom, eine Carboxylgruppe, einen C₁-C₁₂Alkylrest oder einen C₆-C₁₂ Arylrest substituiert ist, wobei besagte Alkyl- oder Arylreste ihrerseits gegebenenfalls durch Halogen oder Hydroxy substituiert sein können, mit der Massgabe, dass besagter Ester wenigstens eine Carbonsäure-, Sulfonsäure- oder Phosphonsäuregruppe oder eine Aminogruppe innerhalb der unter R⁵, R⁶ und R⁸ definierten Reste enthält.

8. Verfahren gemäss Anspruch 7, worin R⁸ eine Carboxylgruppe, eine Sulfonsäuregruppe, eine Phosphonsäuregruppe, einen Rest der Formel -CH₂-SO₃H oder einen Rest der Formel -CHR⁶-Y-R¹⁴-X darstellt, worin R⁶ die in Anspruch 7 angegebene Bedeutung hat R¹⁴ eine divalente aliphatische, aromatische oder araliphatische Gruppe ist, die durch eine Carboxylgruppe, eine Sulfonsäuregruppe oder eine Phosphonsäuregruppe substituiert sein kann, worin Y Schwefel oder einen Rest -NR¹⁵- bedeutet, wobei R¹⁵ Wasserstoff ist oder Alkyl bedeutet, das gegebenenfalls durch eine Carboxylgruppe oder eine gegebenenfalls veretherte Hydroxylgruppe substituiert ist, oder worin R¹⁴ und R¹⁵ zusammen eine C₄-C₅Alkylenkette darstellen, die durch ein Stickstoff- oder Schwefelatom unterbrochen sein kann, worin X eine Carboxylgruppe oder eine Sulfonsäuregruppe ist, oder, falls Y-NR¹⁵- ist, auch Wasserstoff, eine Phosphonsäuregruppe, eine Hydroxylgruppe, oder eine Gruppe -NR¹⁶R¹⁷ sein kann, worin R¹⁶ und R¹⁷ unabhängig voneinander Wasserstoff, Alkyl, Aryl, Aralkyl oder Alkenyl sind, wobei jeder dieser Reste durch eine Hydroxylgruppe substituiert sein kann.

9. Verfahren gemäss Anspruch 7, worin die im Zusammenhang mit der Formel V definierten Alkyl- oder Alkenylreste, sowie der Alkylteil der Aralkylgruppen, die Arylgruppen oder der Arylteil der Aralkylgruppen bis zu 20 Kohlenstoffatome besitzen.

10. Verfahren gemäss Anspruch 7 oder 8, worin p 0 oder 1 bedeutet, und R⁵ Chlor oder Brom ist oder Hydroxy, C₁-C₄Alkoxy, C₁-C₈Alkyl, Carboxyl, eine Sulfonsäuregruppe, einen Rest der Formel -OSO₂R¹², -OSO₂R¹³, -OCOR¹² oder einen Rest der Formel VI bedeutet, worin R⁶ Wasserstoff ist, R⁷ Wasserstoff ist oder C₁-C₄Alkyl bedeutet, das gegebenenfalls durch Hydroxy oder C₁-C₄Alkoxy substituiert ist, oder worin R⁷ ein Rest der Formel -COR¹², -SO₂R¹² oder -SO₂R¹³ ist, wobei R⁷ und r so ausgewählt werden, dass wenigstens 5 % der Gruppen R⁷ -SO₂R¹³ darstellen, worin R⁸ eine Carboxyl- oder Sulfonsäuregruppe ist oder eine Gruppe der Formel -CH₂-NR¹⁵-R¹⁴-X' ist, wobei R¹² und R¹³ die in Anspruch 7 definierten Bedeutungen besitzen, wobei R¹⁴ und R¹⁵ die in Anspruch 8 definierten Bedeutungen besitzen, worin X' Wasserstoff, eine Carboxyl- oder Sulfonsäuregruppe, eine Hydroxylgruppe oder ein Rest -NR¹⁶R¹⁷ ist, worin R¹⁶ und R¹⁷ die in Anspruch 8 definierten Bedeutungen besitzen, und worin q und s so gewählt werden, dass wenigstens 4 % der Gruppen der Formel V einen Rest R⁸ enthalten.

11. Verfahren gemäss Anspruch 7, worin der Ester 2 bis 15 der wiederkehrenden Struktureinheiten der Formel V aufweist, worin p 0 oder 1 ist, R⁵ C₁-C₄Alkyl, Hydroxyl, einen Rest der Formel -OSO₂R¹³, oder eine Gruppe der Formel VI bedeutet, worin Z eine durch eine Carboxylgruppe substituierte Alkylengruppe ist, worin s 0 und r 1 bedeuten, worin R⁶ Wasserstoff ist, R⁷ Wasserstoff oder Methyl, Ethyl, Isopropyl, n-Butyl, 2-Hydroxyethyl, 2-Hydroxypropyl, 2-Methoxyethyl oder 2-Butoxyethyl bedeutet oder Acetyl, Benzoyl, Methansulfonyl, Benzosulfonyl oder p-Toluolsulfonyl ist, oder einen Rest -SO₂R¹³ bedeutet, mit der Massgabe, dass 9 % bis 50 % der Reste R⁷ -SO₂R¹³ sind, worin R⁸ eine Carboxyl- oder Sulfonylgruppe ist oder ein Rest der Formel -CH₂-NR¹⁸R¹⁹ ist, worin R¹³ eine Naphthochinongruppe der Formel VIII ist, worin R¹⁸ Wasserstoff oder C₁-C₄Alkyl ist, das gegebenenfalls durch eine Hydroxylgruppe, eine Aminogruppe oder eine Carboxylgruppe substituiert ist, worin R¹⁹ C₁-C₄-Alkyl oder -Hydroxyalkyl ist, und worin q, für den Fall, dass R⁵ eine Gruppe der Formel VI darstellt, 0 bedeutet und worin q, für den Fall, dass R⁵ keine Gruppe der Formel VI darstellt, so ausgewählt wird, dass wenigstens 10 % der Reste der Formel V eine Gruppe R⁸ besitzen.

12. Verfahren gemäss Anspruch 1, worin die galvanische Abscheidung bei Spannungen bis zu 200 V und in einem Zeitraum bis zu 5 Minuten durchgeführt wird.

## Claims

1. A process for the production of metallic images on the metal surface of a metal-faced laminate, said process comprising the following steps:
a) applying by electrodeposition a layer of a positive photoresist containing both salt-forming groups and photosensitive groups in the same polymer molecule onto the metal-faced laminate, to produce a uniform covering of said positive photoresist,
b) exposing the applied layer to actinic radiation in a predetermined pattern, whereby the areas of the applied layer which are subjected to radiation become more soluble in a developing agent than the nonirradiated areas, and
c) removing the applied layer from the exposed areas by contact with a developer,
d) removing the exposed metal surface using a suitable etching agent, and
e) removing the residual positive photoresist by contact with a suitable solvent.

2. A process according to claim 1, comprising in addition, prior to the final stage e), a further step dl) in which the laminate is subjected to actinic radiation, such that the residual positive photoresist is converted into a more soluble state.

3. A process according to claim 1, where the laminate is metal-coated on both sides and contains apertures which, for their part, are covered with metal.

4. A process according to claim 1, in which the positive photoresist is a compound of the formula I or II 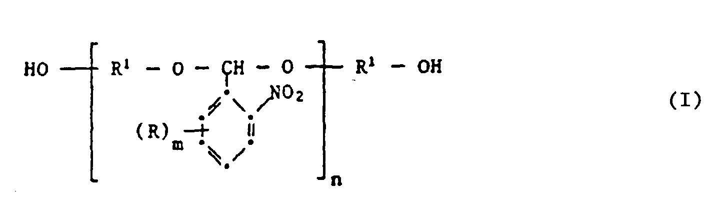 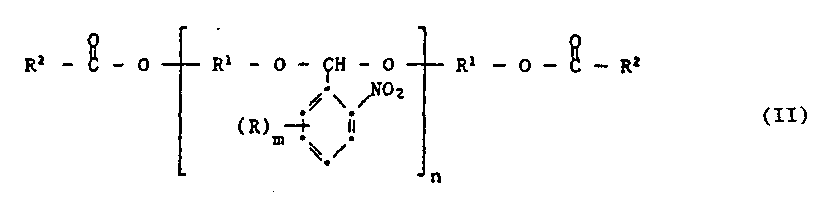 or it is a compound containing the repeating structural unit of the formula III 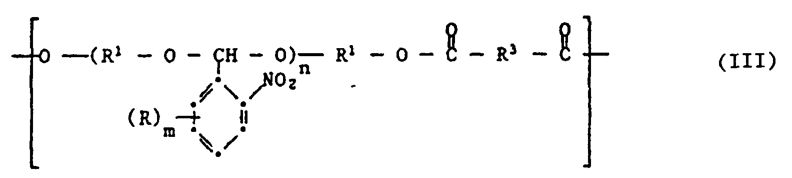 in which
m is 0 or is an integer from 1 to 4,
n is an integer from 1 to 20,
R is alkyl, alkoxy, nitro, amino or carboxyl, such groups being able, within the given definition, to be different when m > 1,
R¹ is a divalent organic radical which may optionally be substituted by an amino or carboxyl group,
R² is a monovalent organic radical which is optionally substituted by an amino or carboxyl group, and
R³ is a divalent organic radical which is optionally substituted by an amino or carboxyl group, with the proviso that at least one of the groups R, R¹, R² and R³ contains an amino or carboxyl group.

5. A process according to claim 4, in which R¹ is C₅-C₁₅alkylene, linear C₄-C₁₅alkylene interrupted by one or more hetero atoms or groups, or linear C₂-C₆alkylene interrupted by a C₅-C₇cycloalkylene group where any of these radicals may be substituted by an amino or carboxyl group, and in which R³ represents C₂-C₁₅alkylene or C₆-C₁₀arylene, these radicals optionally being substituted by an amino group or a carboxyl radical.

6. A process according to claim 1, in which the positive photoresist is a copolymer having a molecular weight of at least 500, the comonomers being an o-nitrocarbinol ester of an unsaturated carboxylic acid and an unsaturated free carboxylic acid, the whole molecule containing at least 5 %, by reference to the molecular weight, of aromatic carbocyclic or aromatic heterocyclic o-nitrocarbinol ester groups of the formula IV 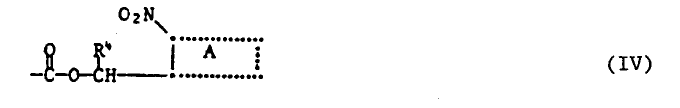 in which A is an aromatic carbocyclic or aromatic heterocyclic ring which may optionally be substituted and has 5 to 14 members, and R⁴ is hydrogen, C₁-C₈alkyl or an optionally substituted aryl or aralkyl group, the optional substituents on A or R⁴ being C₁-C₈alkyl or -alkoxy or being halogen, nitro, amino or carboxyl.

7. A process according to claim 1, in which the positive photoresist is a quinone diazide sulfonyl ester of a phenolic novolak containing at least two of the repeating structural units of the formula V 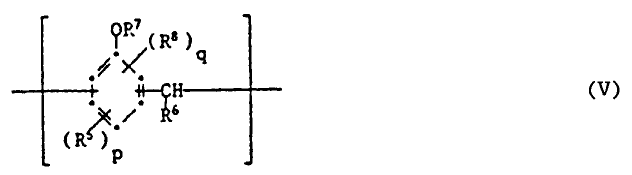 in which R⁵ is halogen, hydroxyl or alkoxy or is an optionally esterified carboxylic acid or sulfonic acid group, or is alkyl, alkenyl or aryl any of which is optionally substituted by a carboxyl group, or R⁵ is a radical of the formula -NR⁹R¹⁰, -COR¹¹, -OCOR¹², -OSO₂R¹² or -OSO₂R¹³, or one of the radicals R⁵ is a group of the formula VI 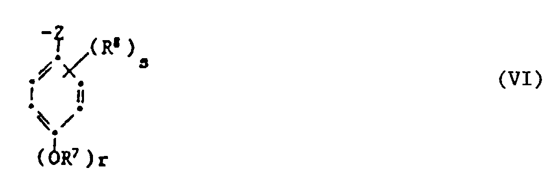 where said group of the formula VI may be connected to adjacent aromatic rings through radicals of the formula -CHR⁶-, p is 0, 1, 2 or 3, r is 0 or 1, s is 0 or 1, R⁶ is hydrogen or alkyl, aryl or carboxyl, R⁷ is hydrogen or is alkyl which is optionally substituted by hydroxyl or alkoxy, or R⁷ is a group of the formula -SO₂R¹³, -SO₂R¹² or -COR¹², at least 4 % of the radicals R⁷ in the ester having the repeating structural units of the formula V being a group of the formula -SO₂R¹³, R⁸ is a salt-forming group, q is 0 or 1, R⁹ is hydrogen or alkyl or is -COR¹², -SO₂R¹² or -SO₂R¹³, R¹⁰ is hydrogen or alkyl, R¹¹ is a monovalent aliphatic or cycloaliphatic radical, R¹² is a monovalent aliphatic, cycloaliphatic, aromatic or araliphatic radical, R¹³ is a 1,2-benzo- or -naphthoquinone diazide group of the formula VII or VIII 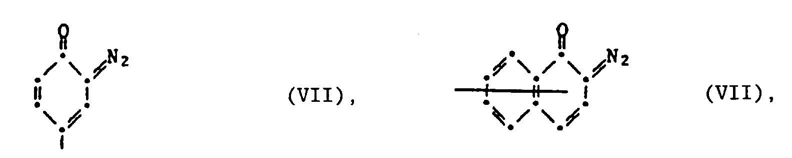 the free valency bond of the naphthoquinone of the formula VIII being in the 4- or 5-position, Z is oxygen, sulfur, carbonyl or sulfonyl or is C₁-C₆alkylene which is optionally substituted by a halogen atom, a carboxyl group, a C₁-C₁₂alkyl radical or a C₆-C₁₂aryl radical, said alkyl or aryl radicals in turn optionally being able to be substituted by halogen or hydroxyl, with the proviso that said ester contains at least one carboxylic acid, sulfonic acid or phosphonic acid group or an amino group within the definitions of the radicals R⁵, R⁶ and R⁸.

8. A process according to claim 7, in which R⁸ is a carboxyl group, a sulfonic acid group, a phosphonic acid group, a radical of the formula -CH₂-SO₃H or a radical of the formula -CHR⁶-Y-R¹⁴-X, in which R⁶ is as defined in claim 7, R¹⁴ is a divalent aliphatic, aromatic or araliphatic group which may be substituted by a carboxyl group, a sulfonic acid group or a phosphonic acid group, Y is sulfur or a radical -NR¹⁵- where R¹⁵ is hydrogen or is alkyl which is optionally substituted by a carboxyl group or an optionally etherified hydroxyl group, or R¹⁴ and R¹⁵ together are a C₄-C₅alkylene chain which may be interrupted by a nitrogen or sulfur atom, X is a carboxyl group or a sulfonic acid group or, when Y is -NR¹⁵-, X may also be hydrogen, a phosphonic acid group, a hydroxyl group or a group -NR¹⁶R¹⁷, in which R¹⁶ and R¹⁷ independently of one another are hydrogen, alkyl, aryl, aralkyl or alkenyl, any of these radicals being able to be substituted by a hydroxyl group.

9. A process according to claim 7, in which the alkyl or alkenyl radicals defined in connection with the formula V, and the alkyl portion of the aralkyl groups, the aryl groups or the aryl portion of the aralkyl groups, have up to 20 carbon atoms.

10. A process according to claim 7 or 8, in which p is 0 or 1 and R⁵ is chlorine or bromine or is hydroxyl, C₁-C₄alkoxy, C₁-C₈alkyl, carboxyl, a sulfonic acid group, a radical of the formula -OSO₂R¹², -OSO₂R¹³, -OCOR¹² or a radical of the formula VI, R⁶ is hydrogen, R⁷ is hydrogen or is C₁-C₄alkyl which is optionally substituted by hydroxyl or C₁-C₄alkoxy, or R⁷ is a radical of the formula -COR¹², -SO₂R¹² or -SO₂R¹³, R⁷ and r being selected such that at least 5 % of the groups R⁷ are -SO₂R¹³, R⁸ is a carboxyl or sulfonic acid group or is a group of the formula -CH₂-NR¹⁵- R¹⁴-X', R¹² and R¹³ being as defined in claim 7, R¹⁴ and R¹⁵ being as defined in claim 8, X' is hydrogen, a carboxyl or sulfonic acid group, a hydroxyl group or a radical -NR¹⁶R¹⁷, in which R¹⁶ and R¹⁷ are as defined in claim 8, and q and s are selected such that at least 4 % of the groups of the formula V contain a radical R⁸.

11. A process according to claim 7, in which the ester has 2 to 15 of the repeating structural units of the formula V in which p is 0 or 1, R⁵ is C₁-C₄alkyl, hydroxyl, a radical of the formula -OSO₂R¹³, or a group of the formula VI, in which Z is an alkylene group substituted by a carboxyl group, s is 0 and r is 1, R⁶ is hydrogen, R⁷ is hydrogen or methyl, ethyl, isopropyl, n-butyl, 2-hydroxyethyl, 2-hydroxypropyl, 2-methoxyethyl or 2-butoxyethyl or is acetyl, benzoyl, methanesulfonyl, benzenesulfonyl or p-toluenesulfonyl, or is a radical -SO₂R¹³, with the proviso that 9 % to 50 % of the radicals R⁷ are -SO₂R¹³, R⁸ is a carboxyl or sulfonyl group or is a radical of the formula -CH₂-NR¹⁸R¹⁹, R¹³ is a naphthoquinone group of the formula VIII, R¹⁸ is hydrogen or C₁-C₄alkyl which is optionally substituted by a hydroxyl group, an amino group or a carboxyl group, R¹⁹ is C₁-C₄alkyl or -hydroxyalkyl and, when R⁵ is a group of the formula VI, q is 0 and, when R⁵ is other than a group of the formula VI, q is selected such that at least 10 % of the radicals of the formula V have a group R⁸.

12. A process according to claim 1, in which the application by electrodeposition is carried out at up to 200 V and for a period of up to 5 minutes.

## Revendications

1. Procédé pour réaliser des images métaliques qui comprend les étapes opératoires suivantes :
a) on dépose par voie électrolytique, sur la surface d'un strafifié plaqué de métal ayant une surface électroconductrice, une couche d'une photolaque fonctionnant en positif qui contient aussi bien des radicaux salifaibles que des groupes photosensibles dans la même molécule de polymère, de manière à former une couverture uniforme en ladite photolaque fonctionnant en positif,
b) on irradie la couche appliquée au moyen d'un modèle donné de rayonnement actinique, les endroits de la couche appliquée qui sont touchés par le rayonnement devenant alors plus solubles dans le développateur que les endroits non touchés par le rayonnement, et
c) on élimine par contact avec un développateur les endroits de la couche appliquée qui ont été touchés par le rayonnement.
d) on élimine, au moyen d'un agent d'attaque approprié, la surface métallique qui a été mise à nu et
e) on élimine, par contact avec un solvant approprié, le reste de la photolaque fonctionnant en positif.

2. Procédé selon la revendication 1 qui comprend en outre, avant la dernière étape opératoire e), une étape supplémentaire dl) selon laquelle le stratifié est exposé à un rayonnement actinique de telle sorte que le reste de la photolaque fonctionnant en positif soit amené à un état plus soluble.

3. Procédé selon la revendication 1, le stratifié étant métallisé sur les deux faces et comportant des ouvertures qui sont pour leur part, recouverte de métal.

4. Procédé selon la revendication 1 dans lequel la photolaque fonctionnant en positif est un composé répondant à l'une des formules I et II : 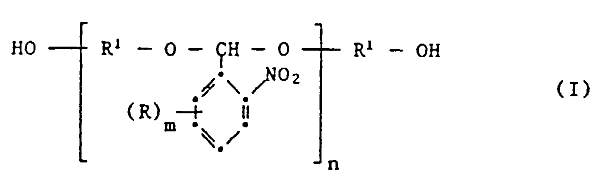 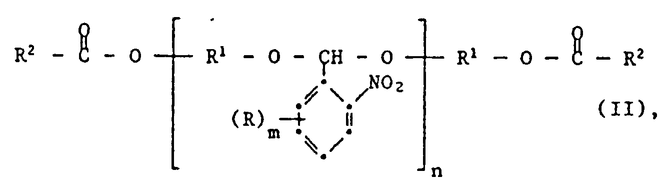 ou un composé contenant une unité structurale répétée de formule III : 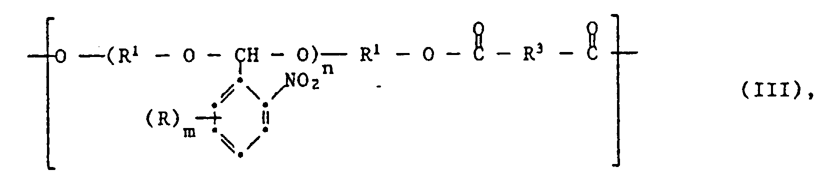 formules dans lesquelles
m désigne un nombre entier de 0 à 4,
n désigne un nombre entier de 1 à 20,
R représente un radical alkyle, alcoxy, nitro, amino ou carboxy et, dans le cas où m est supérieur à 1 et qu'il y a plusieurs radicaux R, ceux-ci peuvent avoir des significations différentes dans le cadre de la définition qui vient d'être donnée,
R¹ représente un radical organique divalent qui porte éventuellement un radical amino ou carboxy,
R² représente un radical organique univalent qui porte éventuellement un radical amino ou carboxy, et
R³ représente un radical organique divalent qui porte éventuellement un radical amino ou carboxy,
avec la condition qu'au moins un des radicaux R, R¹, R² et R³ contienne un radical amino ou carboxy.

5. Procédé selon la revendication 4 dans lequel R¹ représente un alkylène en C₅-C₁₅, un alkylène linéaire en C₄-C₁₅ interrompu par un ou plusieurs hétéro-atomes ou radicaux hétéro-atomiques ou un alkylène en C₂-C₆ linéaire interrompu par un cycloalkylène en C₅-C₇, chacun de ces radicaux pouvant porter un radical amino ou carboxy, et R³ représente un alkylène en C₂-C₁₅ ou un arylène en C₆-C₁₀, chacun de ces radicaux portant éventuellement un radical amino ou un radical carboxy.

6. Procédé selon la revendication 1 dans lequel la photolaque fonctionnant positivement est un copolymère qui a une masse moléculaire d'au moins 500 et qui contient, comme comonomères, un ester formé par un o-nitrocarbinol avec un acide insaturé et un acide carboxylique insaturé libre, au moins 5 % de la molécule totale (relativement à la masse moléculaire) contenant des radicaux d'esters d'o-nitrocarbinols aromatiques-carbocycliques ou aromatiques-hétérocycliques répondant à la formule IV : 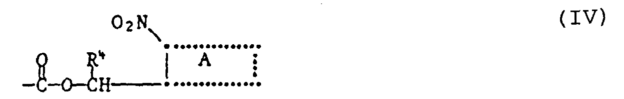 dans laquelle
A représente un cycle aromatique-carbocyclique ou aromatique-hétérocyclique éventuellement substitué qui contient de 5 à 14 maillons, et
R⁴ représente l'hydrogène, un alkyle en C₁-C₈ ou un radical aryle ou aralkyle éventuellement substitué, les substituants éventuellement présents sur A ou R⁴ étant des radicaux alkyles ou alcoxy en C₁-C₈ ou étant un halogène, un nitro, un amino ou un carboxy.

7. Procédé selon la revendication 1 dans lequel la photolaque fonctionnant en positif est un ester quinone-diazide-sulfonylique d'une novolaque phénolique, ester qui contient au moins deux unités structurales répétées répondant à la formule V : 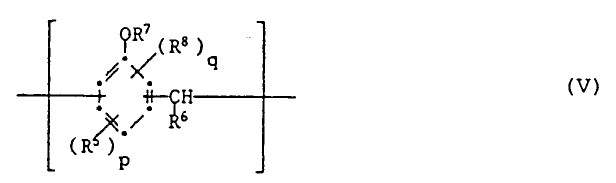 dans laquelle
R⁵ représente un halogène, un hydroxy ou un alcoxy, ou un radical d'acide carboxylique ou d'acide sulfonique éventuellement estérifié, ou un radical alkyle, alcényle ou aryle éventuellement porteur d'un carboxy, ou R⁵ représente un radical -NR⁹R¹⁰, -COR¹¹, -OCOR¹², -OSO₂R¹² ou -OSO₂R¹³, ou l'un des symboles R⁵ représente un radical de formule VI : 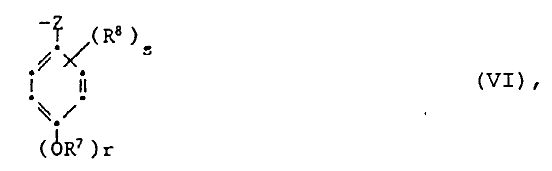 ledit radical de formule VI pouvant être lié à des cycles aromatiques voisins par des radicaux -CHR⁶-,
p est égal à 0, à 1, à 2 ou à 3,
r est égal à 0 ou à 1,
s est égal à 0 ou à 1,
R⁶ représente l'hydrogène, un alkyle, un aryle ou un carboxy,
R⁷ représente l'hydrogène, un alkyle éventuellement porteur d'un hydroxy ou d'un alcoxy, ou un radical -SO₂R¹³, -SO₂R¹² ou -COR¹², au moins 4 % des radicaux R⁷ de l'ester à unités structurales répétées de formule V étant des radicaux -SO₂R¹³,
R⁸ représente un radical salifiable,
q est égal à 0 ou à 1,
R⁹ représente l'hydrogène, un alkyle ou un radical -COR¹², -SO₂R¹² ou -SO₂R¹³,
R¹⁰ représente l'hydrogène ou un alkyle,
R¹¹ représente un radical aliphatique ou cycloaliphatique univalent,
R¹² représente un radical aliphatique, cycloaliphatique, aromatique ou araliphatique univalent,
R¹³ représente un radical de 1,2-benzoquinone- ou naphtoquinone-diazide répondant respectivement aux formules VII et VIII : 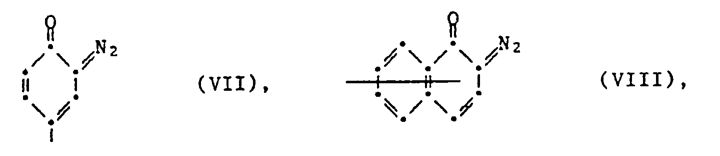 la valence libre, sur la naphtoquinone de formule VIII, se trouvant à la position 4 ou à la position 5,
Z représente l'oxygène, le soufre, un carbonyle ou un sulfonyle ou représente un alkylène en C₁-C₆ éventuellement porteur d'un atome d'halogène, d'un radical carboxy, d'un alkyle en C₁-C₁₂ ou d'un aryle en C₆-C₁₂, lesdits radicaux alkyles et aryles pouvant, de leur côté, porter éventuellement un halogène ou un hydroxy,
avec la condition que lesdits esters contiennent au moins un radical carboxy, sulfo ou phosphono ou un radical amino répondant aux définitions qui ont été données pour R⁵, R⁶ et R⁸.

8. Procédé selon la revendication 7 dans lequel R⁸ représente un radical carboxy, un radical sulfo, un radical phosphono, un radical -CH₂-SO₃H ou un radical -CHR⁶-Y-R¹⁴-X, R⁶ a la signification qui lui a été donnée à la revendication 7, R¹⁴ représente un radical aliphatique, aromatique ou araliphatique divalent qui peut porter un radical carboxy, un radical sulfo ou un radical phosphono, Y représente le soufre ou un radical -NR¹⁵-, le symbole R¹⁵ désignant l'hydrogène ou un alkyle éventuellement porteur d'un carboxy ou d'un radical hydroxy éventuellement éthérifié, ou R¹⁴ et R¹⁵ forment ensemble une chaîne alkylène à 4 ou 5 atomes de carbone qui peut être interrompue par un atome d'azote ou de soufre, X représente un radical carboxy ou un radical sulfo ou encore, dans le cas où Y représente -NR¹⁵-, X peut aussi représenter l'hydrogène, un radical phosphono, un radical hydroxy ou un radical -NR¹⁶R¹⁷, et R¹⁶ et R¹⁷ représentent chacun, indépendamment l'un de l'autre, l'hydrogène, un alkyle, un aryle, un aralkyle ou un alcényle, chacun de ces radicaux pouvant porter un radical hydroxy.

9. Procédé selon la revendication 7 dans lequel les radicaux alkyles et alcényles définis en relation avec la formule V ainsi que la partie alkyle des radicaux aralkyles, les radicaux aryles ou la partie aryle des radicaux aralkyles contiennent jusqu'à 20 atomes de carbone.

10. Procédé selon la revendication 7 ou 8 dans lequel p est égal à 0 ou à 1, R⁵ représente le chlore, le brome, un hydroxy, un alcoxy en C₁-C₄, un alkyle en C₁-C₈, un carboxy, un sulfo, un radical -OSO₂R¹², -OSO₂R¹³ ou -OCOR¹² ou un radical de formule VI, R⁶ représente l'hydrogène, R⁷ représente l'hydrogène, un alkyle en C₁-C₄ éventuellement porteur d'un hydroxy ou d'un alcoxy en C₁-C₄, ou un radical -COR¹², -SO₂R¹² ou -SO₂R¹³, R⁷ et r étant choisis de telle façon qu'au moins 5 % des radicaux R⁷ soient des radicaux -SO₂R¹³, R⁸ représente un radical carboxy ou sulfo ou un radical -CH₂-NR¹⁵-R¹⁴-X', R¹² et R¹³ ont les significations qui leur ont été données à la revendication 7, R¹⁴ et R¹⁵ ont les significations qui leur ont été données à la revendication 8, X' représente l'hydrogène, un carboxy, un sulfo, un hydroxy ou un radical -NR¹⁶R¹⁷, R¹⁶ et R¹⁷ ont les significations qui leur ont été données à la revendication 8, et q et s sont choisis de telle façon qu'au moins 4 % des radicaux de formule V contiennent un radical R⁸.

11. Procédé selon la revendication 7 dans lequel l'ester contient de 2 à 15 des unités structurales répétées de formule V dans lesquelles p est égal à 0 ou à 1, R⁵ représente un alkyle en C₁-C₄, un hydroxy, un radical -OSO₂R¹³ ou un radical de formule VI, Z représente un radical alkylène porteur d'un carboxy, s est égal à 0, r est égal à 1, R⁶ représente l'hydrogène, R⁷ représente l'hydrogène, un radical méthyle, éthyle, isopropyle, n-butyle, 2-hydroxy-éthyle, 2-hydroxy-propyle, 2-méthoxy-éthyle, 2-butoxy-éthyle, acétyle, benzoyle, méthane-sulfonyle, benzène-sulfonyle ou p-toluène-sulfonyle ou un radical -SO₂R¹³ avec la condition que de 9 à 50 % des radicaux R⁷ soient des radicaux -SO₂R¹³, R⁸ représente un radical carboxy ou sulfo ou un radical -CH₂-NR¹⁸R¹⁹, R¹³ représente un radical de naphtoquinone de formule VIII, R¹⁸ représente l'hydrogène ou un alkyle en C₁-C₄ éventuellement porteur d'un hydroxy, d'un amino ou d'un carboxy, R¹⁹ représente un radical alkyle ou hydroxyalkyle en C₁-C₄, et q est égal à 0 lorsque R⁵ représente un radical de formule VI et a, lorsque R⁵ ne représente pas un radical de formule VI, une valeur telle qu'au moins 10 % des radicaux de formule V contiennent un radical R⁸.

12. Procédé selon la revendication 1 dans lequel la déposition électrolytique est effectuée sous des tensions pouvant aller jusqu'à 200 V et en un temps pouvant aller jusqu'à 5 minutes.
